# EUROPEAN PATENT APPLICATION

(11) **EP 4 646 056 A1**
(43) Date of publication of application: **05.11.2025**
(21) Application number: 24216021.6
(22) Date of filing: 28.11.2024
(51) Int. Cl.: H10D 84/05, H01L 23/525, H10D 30/47, H10D 84/80

(54) **SEMICONDUCTOR DEVICE**

(30) Priority: 30.04.2024 KR 20240057998
(71) Applicant: Samsung Electronics Co., Ltd., Suwon-si, Gyeonggi-do 16677 (KR)
(72) Inventor: KIM, Jin-Hwan, Suwon-si (KR); HWANG, In Jun, Suwon-si (KR)
(74) Representative: Marks & Clerk LLP

(57) **Abstract**

A semiconductor device includes a main transistor and an anti-fuse connected to one terminal of the main transistor, wherein the main transistor includes a main channel layer, a main gate electrode above the main channel layer, and a main source electrode and a main drain electrode on both sides of the main gate electrode and connected to the main channel layer, the anti-fuse includes a sub-channel layer, a sub-barrier layer above the sub-channel layer and including a material having a different energy band gap than the sub-channel layer, a sub-gate electrode above the sub-channel layer, a gate semiconductor pattern between the sub-channel layer and the sub-gate electrode, and a sub-source electrode above the sub-channel layer and on one side of the sub-gate electrode, and the main source electrode and the sub-gate electrode, or the main source electrode and the sub-source electrode are electrically connected to each other.

## Description

### BACKGROUND

### 1. Field

The present disclosure relates to semiconductor devices.

### 2. Description of the Related Art

In modern society, semiconductor devices are closely related to a daily life. In particular, an importance of electric power semiconductor devices used in various fields such as transportation fields (e.g., electric vehicles, railways, and electric trams), renewable energy systems (e.g., solar power generation and wind power generation), and mobile devices is gradually increasing. The electric power semiconductor device is a semiconductor device used to handle high voltage or high current, and performs functions such as an electric power conversion and control in large-sized electric power systems or high power electronic devices. The electric power semiconductor devices have an ability and durability to handle high electric power, thereby handling a large amount of current, and withstanding high voltages. For example, the electric power semiconductor device can handle voltages of hundreds to thousands of volts and currents of tens of amperes to thousands of amperes. The electric power semiconductor devices may improve an efficiency of an electrical energy by minimizing a power loss. Additionally, the electric power semiconductor devices may be operated stably even in environments such as high temperature.

These electric power semiconductor devices may be classified depending on a material, and examples include a SiC electric power semiconductor device and a GaN electric power semiconductor device. By manufacturing the electric power semiconductor devices by using SiC or GaN instead of conventional silicon wafers (Si wafers), drawbacks of silicon (e.g., unstable characteristics at high temperatures) may be compensated. The GaN electric power semiconductor device requires high costs, but may be efficient in terms of a speed and may be suitable for high-speed charging of mobile devices.

### SUMMARY

Some embodiments provide semiconductor devices with stable electric characteristics and improved reliability.

A semiconductor device according to an embodiment includes a main transistor, and an anti-fuse connected to one terminal of the main transistor, wherein the main transistor includes a main channel layer, a main gate electrode above the main channel layer, and a main source electrode and a main drain electrode on both sides (i.e. on a first side and a second side respectively) of the main gate electrode, respectively, the main source electrode and the main drain electrode being connected to the main channel layer, the anti-fuse includes a sub-channel layer including a sub-drift area with a 2-dimensional electron gas, a sub-barrier layer above the sub-channel layer, the sub-barrier layer including a material having an energy band gap different from that of the sub-channel layer, a sub-gate electrode above the sub-channel layer, a gate semiconductor pattern between the sub-channel layer and the sub-gate electrode, and a sub-source electrode above the sub-channel layer, the sub-source electrode being on one side of the sub-gate electrode, and the main source electrode and the sub-gate electrode or the main source electrode and the sub-source electrode are electrically connected to each other.

A semiconductor device according to an embodiment includes a main transistor and an anti-fuse connected to one terminal of the main transistor, wherein the main transistor includes a main channel layer, a main barrier layer above the main channel layer, the main barrier layer including a material having an energy band gap different from that of the main channel layer, a main gate electrode above the main barrier layer, a gate semiconductor layer between the main barrier layer and the main gate electrode, and a main source electrode and a main drain electrode on both sides of the main gate electrode, respectively, the main source electrode and the main drain electrode being connected to the main channel layer, the anti-fuse includes a sub-channel layer including a sub-drift area with a 2-dimensional electron gas, a sub-barrier layer above the sub-channel layer, the sub-barrier layer including a same material as the gate semiconductor layer, a sub-gate electrode above the sub-channel layer, a gate semiconductor pattern between the sub-channel layer and the sub-gate electrode, a sub-source electrode above the sub-channel layer, the sub-source electrode being on one side of the sub-gate electrode, and a protection layer covering the sub-barrier layer and the sub-gate electrode, and the main source electrode and the sub-gate electrode, or the main source electrode and the sub-source electrode are electrically connected to each other, on the protection layer.

A semiconductor device according to an embodiment includes a main transistor and an anti-fuse connected to one terminal of the main transistor, wherein the main transistor includes a main channel layer including GaN, a main gate electrode above the main channel layer, and a main source electrode and a main drain electrode on both sides of the main gate electrode, respectively, the main source electrode and the main drain electrode being connected to the main channel layer, the anti-fuse includes a sub-channel layer including GaN, a sub-barrier layer above the sub-channel layer, the sub-barrier layer including AlGaN, a sub-gate electrode above the sub-channel layer, a gate semiconductor pattern between the sub-channel layer and the sub-gate electrode, the gate semiconductor pattern including GaN doped with P-type impurity, and a sub-source electrode above the sub-channel layer, the sub-source electrode being on one side of the sub-gate electrode, and one of the sub-source electrode and the sub-gate electrode is electrically connected to the main source electrode.

According to some embodiments, electric characteristics and reliability of the semiconductor device may be improved.

At least some of the above and other features of the invention are set out in the claims'

### BRIEF DESCRIPTION OF THE DRAWINGS

FIG. 1 is a block diagram showing a semiconductor device according to an embodiment.
FIG. 2 is a circuit diagram showing a semiconductor device according to an embodiment.
FIG. 3 is a top plan view showing a semiconductor device according to an embodiment.
FIG. 4 and FIG. 5 are cross-sectional views cut along a line A-A' in FIG. 3.
FIG. 6 is a cross-sectional view taken along a line B-B' in FIG. 3.
FIG. 7 is a cross-sectional view taken along a line C-C' in FIG. 3.
FIG. 8 is a cross-sectional view showing a current path formed in an anti-fuse of a semiconductor device according to an embodiment.
FIG. 9 and FIG. 10 are cross-sectional views of semiconductor devices according to some embodiments taken along a line C-C' of FIG. 3.
FIG. 11 is a circuit diagram showing a semiconductor device according to an embodiment.
FIG. 12 is a top plan view showing the semiconductor device of FIG. 11.
FIG. 13 is a cross-sectional view taken along a line D-D' in FIG. 12.
FIG. 14 is a circuit diagram showing a semiconductor device according to an embodiment.
FIG. 15 is a top plan view showing the semiconductor device of FIG. 14.
FIG. 16 is a block diagram showing a semiconductor device according to an embodiment.
FIG. 17 and FIG. 18 are circuit diagrams showing semiconductor devices according to some embodiments.
FIG. 19 is a cross-sectional view showing a semiconductor device of FIG. 18, taken along a line C-C' in FIG. 3.
FIG. 20 is a circuit diagram showing a semiconductor device according to an embodiment.
FIG. 21 is a top plan view showing the semiconductor device of FIG. 20.
FIG. 22 is a cross-sectional view taken along a line E-E' of FIG. 21.
FIG. 23 is a circuit diagram showing a semiconductor device according to an embodiment.
FIG. 24 is a top plan view showing the semiconductor device of FIG. 23.
FIG. 25 to FIG. 27 are circuit diagrams showing a plurality of units of semiconductor devices according to some embodiments.

### DETAILED DESCRIPTION

The present inventive concepts will be described more fully hereinafter with reference to the accompanying drawings, in which some embodiments of the inventive concepts are shown. As those skilled in the art would realize, the described embodiments may be modified in various different ways, all without departing from the scope of the present inventive concepts.

Parts unrelated to the description of the embodiments are not shown to make the description clear, and like reference numerals designate like element throughout the specification.

The size and thickness of the configurations are optionally shown in the drawings for convenience of description, and the present inventive concepts are not limited to the drawings. In the drawings, the thickness of layers, films, panels, areas, etc., are exaggerated for clarity. In the drawings, for understanding and ease of description, the thickness of some layers and areas is exaggerated.

It will be understood that when an element such as a layer, film, area, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly described to the contrary, the word "comprise", and variations such as "comprises" or "comprising", will be understood to imply the inclusion of stated elements but not the exclusion of any other elements.

Further, throughout the specification, the word "on a plane" means viewing a target portion from the top, and the word "on a cross section" means viewing a cross section formed by vertically cutting a target portion from the side.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

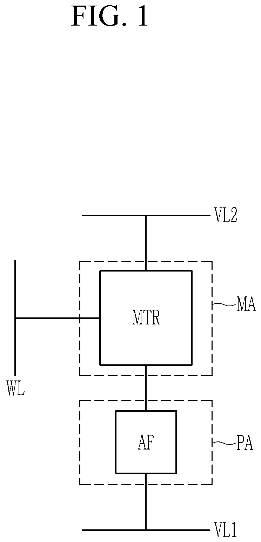

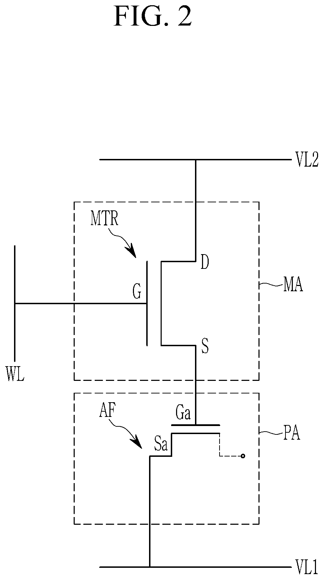

Hereinafter, a circuit structure of a semiconductor device according to an embodiment will be described with reference to FIG. 1 and FIG. 2.

FIG. 1 is a block diagram showing a semiconductor device according to an embodiment. FIG. 2 is a circuit diagram showing a semiconductor device according to an embodiment.

First, as shown in FIG. 1 and FIG. 2, a semiconductor device according to an embodiment may include a main element area MA including a main transistor MTR, and a peripheral circuit area PA including an anti-fuse AF.

The main transistor MTR may be positioned in the main element area MA. For example, the main transistor MTR of the semiconductor device according to an embodiment may be a normally off high electron mobility transistor (HEMT). However, it is not limited thereto, the main transistor MTR of the semiconductor device according to an embodiment may be a normally-on high electron mobility transistor. In an embodiment, the main element area MA may mean an area in which the main transistor MTR is placed.

In an embodiment, the main transistor MTR may be a redundancy element to replace a defective element when it occurs. For example, if the defective device occurs among the plurality of semiconductor devices, the main transistor MTR may replace the defective device and operate.

One terminal of the main transistor MTR may be electrically connected to a second voltage line VL2 that supplies a second power voltage, and the other terminal of the main transistor MTR may be electrically connected to the anti-fuse AF. The other terminal of the main transistor MTR may be electrically connected to a first voltage line VL1, which supplies a first power voltage depending on the state of anti-fuse AF, through the anti-fuse AF. At this time, the magnitude of the first power voltage may be smaller than the magnitude of the second power voltage. For example, the first power voltage may be a ground voltage.

The peripheral circuit area PA of the semiconductor device according to an embodiment may include elements electrically connected to the main transistor MTR. For example, the peripheral circuit area PA of the semiconductor device according to an embodiment may include the anti-fuse AF that is electrically connected to one terminal of the main transistor MTR. Here, the anti-fuse AF has an electric characteristic opposite to that of a fuse element such that in the unprogrammed state, a current does not flow, but in a programmed state, it is a resistive fuse element having an irreversible characteristic that allows a current to flow with a low resistance value. In an embodiment, the anti-fuse AF may be implemented as at least part of a normally on high electron mobility transistor, but it is not limited thereto. In an embodiment, the peripheral circuit area PA may mean an area where the anti-fuse AF is placed.

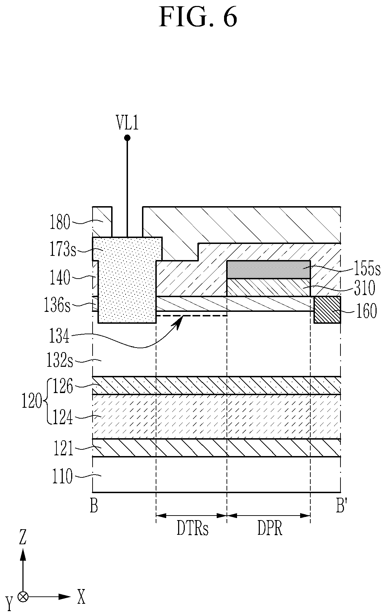

In one embodiment, one terminal of the anti-fuse AF may be electrically connected to the main transistor MTR, and the other terminal of the anti-fuse AF may be electrically connected to the first voltage line VL1 that supplies the first power voltage. The anti-fuse AF may be programmed based on a signal applied from outside or one terminal of the main transistor MTR. For example, according to the signal applied to the anti-fuse AF, a Schottky contact between the gate semiconductor pattern (310 in FIG. 6) and the sub-gate electrode (155s in FIG. 6) is destroyed and converted into an Ohmic contact. At this time, the anti-fuse AF may be converted to a state with a relatively low resistance. Using these properties, the main transistor MTR of the semiconductor device according to an embodiment may be operated as a redundancy element. For example, when the defective element occurs among the plurality of semiconductor devices, the main transistor MTR may operate by replacing the defective element. As another example, if a deviation occurs in the size, phase, etc. of the signal of the semiconductor device according to an embodiment, the anti-fuse AF may be programmed to perform a function to correct the deviation. A detailed description of this is described later with reference to FIG. 2.

In an embodiment, it may further include a controller electrically connected to the main transistor MTR and/or the anti-fuse AF. The controller may detect whether the defective element occurs among the plurality of semiconductor devices. When the defective element occurs, the controller may control the main transistor MTR to operate by replacing the defective element.

In an embodiment, various elements that perform additional operations may be further disposed in the peripheral circuit area PA. For example, passive elements such as capacitors or inductors or active elements such as IC (integrated circuit) chips may be placed in the peripheral circuit area PA. As another example, a current divider, a voltage divider, a voltage clipper, a protection element of the main transistor MTR, etc. may be further placed in the peripheral circuit area PA. As another example, elements that perform compensation and protection functions to ensure that the current flowing through the main transistor MTR and/or the anti-fuse AF operates within a desired (or predetermined) range may be further placed in the peripheral circuit area PA. The protection element may be circuits that mitigate or prevent the semiconductor device including the main transistor MTR from being destroyed. For example, the protection elements may bean overcurrent protection element, an overvoltage protection element, an over temperature protection element, a disconnection protection element, an electro static discharge protection element, or a low drop-output (LDO) regulator.

Hereinafter, a structure and a driving method of a semiconductor device according to an embodiment will be described further with reference to FIG. 2.

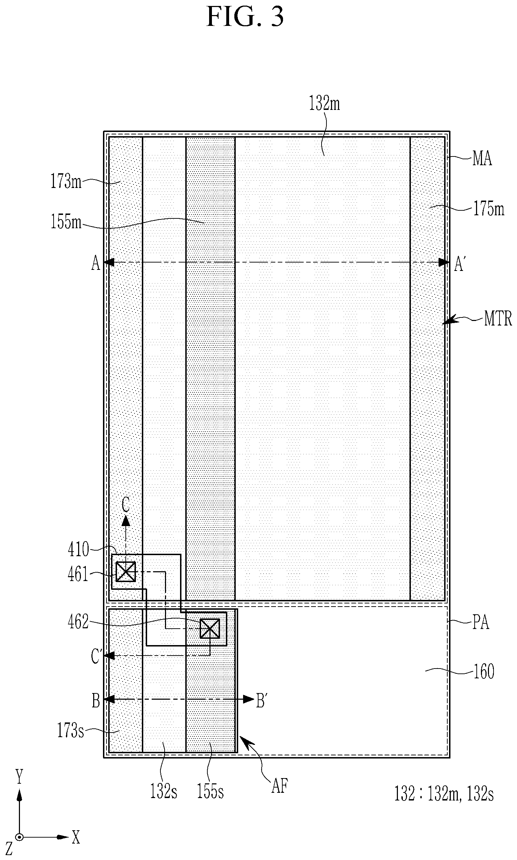

Further referring to FIG. 2, the main transistor MTR may include a gate electrode G, a first electrode D, and a second electrode S. The gate electrode G of the main transistor MTR may be electrically connected to a word line WL to apply gate voltages. The first electrode D of the main transistor MTR may be electrically connected to the second voltage line VL2 which supplies the second power voltage. Additionally, the second electrode S of the main transistor MTR may be electrically connected to one terminal of the anti-fuse AF. The main transistor MTR may control a drain-source current between the first electrode D and the second electrode S according to the gate signal applied to the gate electrode G. Here, the first electrode D may refer to the main drain electrode (175m in FIG. 3) of the main transistor MTR according to an embodiment, the gate electrode G may refer to the main gate electrode (155m in FIG. 3) of the main transistor MTR according to an embodiment, and the second electrode S may refer to the main source electrode (173m in FIG. 3) of the main transistor MTR according to an embodiment. Additionally, the second power voltage may refer to the voltage supplied to the main drain electrode (175m in FIG. 3) of the main transistor MTR.

The anti-fuse AF may include a gate electrode Ga and a second electrode Sa. The gate electrode Ga of the anti-fuse AF may be electrically connected to the second electrode S of the main transistor MTR. The second electrode Sa of the anti-fuse AF may be electrically connected to the first voltage line VL1, which supplies the first power voltage.

The anti-fuse AF can be programmed to have a small resistance value between the gate electrode Ga and the second electrode Sa depending on the signal applied to the gate electrode Ga. For example, when a voltage greater than a breakdown voltage of the gate semiconductor pattern (310 in FIG. 6) is applied to the gate electrode Ga of the anti-fuse AF, the Schottky contact between the gate semiconductor pattern (310 in FIG. 6) and the gate electrode Ga may be destroyed and converted into an ohmic contact. At this time, the anti-fuse AF may be converted to a state with relatively low resistance, and a current may flow between the gate electrode Ga and the second electrode Sa. Meanwhile, when a voltage smaller than the breakdown voltage of the gate semiconductor pattern (310 in FIG. 6) is applied to the gate electrode Ga of the anti-fuse AF, a Schottky contact may be maintained between the gate semiconductor pattern (310 in FIG. 6) and the gate electrode Ga. In other words, the current need not flow between the gate electrode Ga and the second electrode Sa.

Here, the second electrode Sa of the anti-fuse AF may mean a sub-source electrode (173s in FIG. 3) of the anti-fuse AF according to an embodiment, and the gate electrode Ga of the anti-fuse AF may mean a sub-gate electrode (155s in FIG. 3) of the anti-fuse AF according to an embodiment. The anti-fuse AF may be composed of a part of the main transistor MTR separated by a separation structure (160 in FIG. 3) and positioned in the peripheral circuit area PA, but embodiments are not limited thereto.

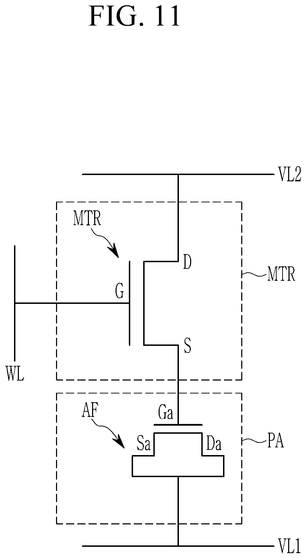

FIG. 2 shows that the anti-fuse AF includes the gate electrode Ga and the second electrode Sa, and the gate electrode Ga is electrically connected to the second electrode S of the main transistor MTR, but embodiments are not limited thereto. For example, a separate wiring for applying a second gate voltage to the gate electrode Ga of the anti-fuse AF may be further provided. In some example embodiments, the anti-fuse AF may further include a first electrode (Da in FIG. 11). At this time, the connection relationship between the anti-fuse AF and the main transistor MTR may be changed in various ways. A detail explanation of this will be explained below in FIG. 11.

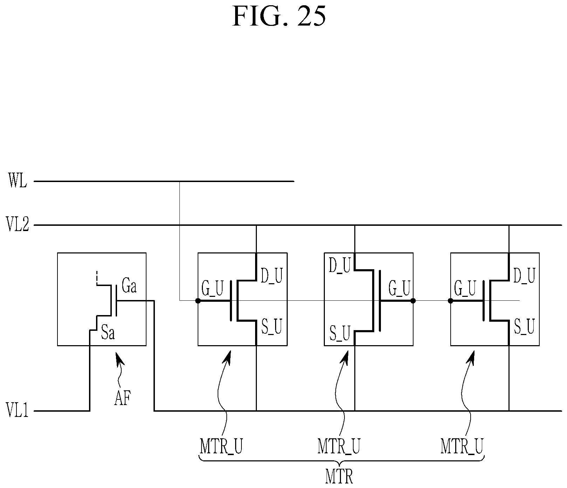

Also, FIG. 2 shows that the main transistor MTR includes one gate electrode G, one first electrode D, and one second electrode S, but embodiments are not limited thereto. For example, the main transistor MTR of the semiconductor device according to some embodiments may include a plurality of units, and each of the plurality of units may include the gate electrode G, the first electrode D, and the second electrode S. A detailed description of this will be explained in FIG. 25 to FIG. 27.

Below, the operation method of the semiconductor device according to an embodiment will be described.

First, in a first mode, the first gate voltage may be applied to the word line WL. Additionally, the first power voltage may be supplied to the first voltage line VL1, and the second power voltage may be supplied to the second voltage line VL2. At this time, the first power voltage may be smaller than the second power voltage. For example, the first power voltage may be a ground voltage, but embodiments are not limited thereto.

In an embodiment, the word line WL may apply the first gate voltage to the gate electrode G of the main transistor MTR. At this time, the first gate voltage may be greater than a threshold voltage of the main transistor MTR. Here, the threshold voltage of the main transistor MTR may mean a minimum voltage at which the main transistor MTR can be turned on. Additionally, the first gate voltage may be smaller than the breakdown voltage of the gate semiconductor pattern (310 in FIG. 3) of the anti-fuse AF. Here, the breakdown voltage of the gate semiconductor pattern (310 in FIG. 3) may mean a minimum voltage at which the Schottky contact between the gate semiconductor pattern (310 in FIG. 3) and the sub-gate electrode (155s in FIG. 3) is destroyed and converted into an ohmic contact. For example, the breakdown voltage of the gate semiconductor pattern (310 in FIG. 3) may be 6V to 10V, but embodiments are not limited thereto.

Accordingly, because the magnitude of the first gate voltage is smaller than the magnitude of the breakdown voltage of the gate semiconductor pattern (310 in FIG. 3) of the anti-fuse AF, the Schottky contact between the gate semiconductor pattern (310 in FIG. 6) of the anti-fuse AF and the sub-gate electrode (155s in FIG. 6) need not be destroyed. In other words, the anti-fuse AF may remain open state. Here, the open state may mean a state in which no current flows the sub-gate electrode (155s of FIG. 6) and the first electrode Sa by the Schottky contact between the gate semiconductor pattern (310 in FIG. 6) and the sub-gate electrode (155s in FIG. 6)

In other words, there may be a relatively large resistance value between the gate semiconductor pattern (310 in FIG. 6) and the sub-gate electrode (155s in FIG. 6). Therefore, the second electrode S of the main transistor MTR may be not electrically connected to the first voltage line VL1 due to the anti-fuse AF. In other words, the second electrode S of the main transistor MTR may be floating.

In summary, even when the first gate voltage greater than the threshold voltage of the main transistor MTR is applied to the gate electrode G of the main transistor MTR, because the anti-fuse AF remains open, the current need not flow through the main transistor MTR.

Afterwards, in a second mode, a second gate voltage may be applied to the word line WL. The word line WL may apply the second gate voltage to the gate electrode G of the main transistor MTR. At this time, the second gate voltage may be greater than the first gate voltage. The second gate voltage may be greater than or equal to the breakdown voltage of the gate semiconductor pattern (310 in FIG. 6) of the anti-fuse AF. Accordingly, the Schottky contact between the gate semiconductor pattern (310 in FIG. 6) of the anti-fuse AF and the sub-gate electrode (155s in FIG. 6) may be destroyed and converted into the ohmic contact. That is, the anti-fuse AF may be in a short state. Here, the short state may mean a state in which the Schottky contact between the gate semiconductor pattern (310 in FIG. 6) and the sub-gate electrode (155s in FIG. 6) is destroyed and converted to the ohmic contact. At this time, it means a state with a relatively low resistance value between the gate semiconductor pattern (310 in FIG. 6) and the sub-gate electrode (155s in FIG. 6). Therefore, a current path may be formed from the gate electrode Ga of the anti-fuse AF to the second electrode Sa of the anti-fuse AF. Accordingly, the second electrode S of the main transistor MTR is electrically connected to the first voltage line VL1 where the first power voltage is supplied.

Subsequently, in the first mode again, the first gate voltage may be applied to the word line WL. At this time, because the anti-fuse AF has been short-circuited, the second electrode S of the main transistor MTR may be electrically connected to the first voltage line VL1 through the anti-fuse AF. Therefore, when the first gate voltage is applied to the gate electrode G of the main transistor MTR, the main transistor MTR may be turned on and the current may flow through the main transistor MTR.

In summary, when the anti-fuse AF is in the open state, the main transistor MTR may be not turned on even if the first gate voltage is applied to the word line WL. When the anti-fuse AF is shorted, the main transistor MTR may be turned on when the first gate voltage is applied to word line WL. When the second gate voltage is applied to the word line WL, the anti-fuse AF may be converted from the open state to the shorted state. In other words, by destroying the Schottky contact between the gate semiconductor pattern (310 in FIG. 6) of the anti-fuse AF and the sub-gate electrode (155s in FIG. 6), the main transistor MTR may be controlled to operate.

Hereinafter, the main transistor of the semiconductor device according to an embodiment will be described with reference to FIG. 3 to FIG. 5.

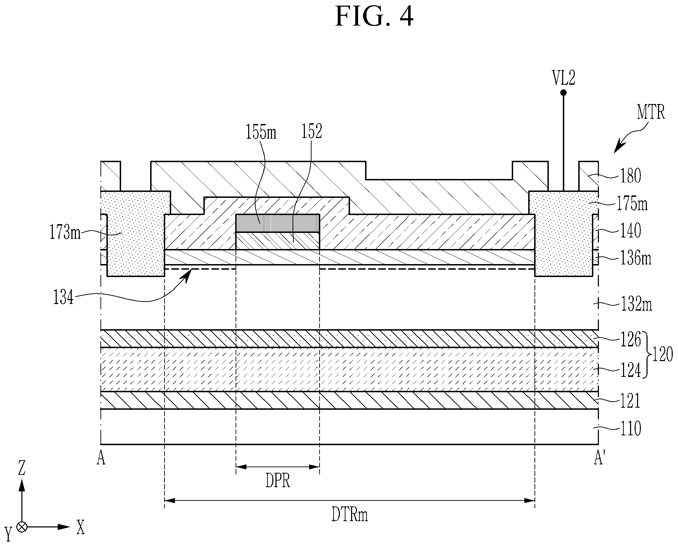

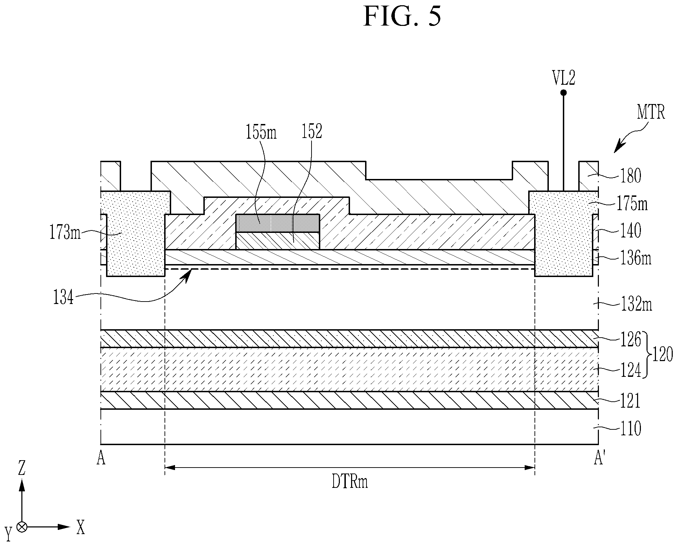

FIG. 3 is a top plan view showing a semiconductor device according to an embodiment. FIG. 4 and FIG. 5 are cross-sectional views cut along a line A-A' in FIG. 3. FIG. 4 represents a case where the semiconductor device according to an embodiment is in an off state. FIG. 5 represents a case where the semiconductor device according to an embodiment is in the on state.

First, referring to FIG. 3, the peripheral circuit area PA of the semiconductor device according to an embodiment may be positioned spaced apart from the main element area MA. For example, the peripheral circuit area PA may be positioned away from the main element area MA in the second direction (a direction Y), but embodiments not limited thereto. As another example, the peripheral circuit area PA may be positioned away from the main element area MA in the first direction (the direction X), or may surround the side of the main element area MA. Of course, various other changes are possible. In an embodiment, a separation structure 160 may be positioned between the peripheral circuit area PA and the main element area MA, but embodiments are not limited thereto.

Further referring to FIG. 4, the main transistor MTR of the semiconductor device according to an embodiment may include a main channel layer 132m, a main barrier layer 136m placed on the main channel layer 132m, a main gate electrode 155m placed on the main barrier layer 136m, a gate semiconductor layer 152 placed between the main barrier layer 136m and the main gate electrode 155m, protection layers 140 and 180 placed on the main barrier layer 136m, and a main source electrode of 173m and a main drain electrode of 175m spaced apart from each other over the main channel layer 132m.

The main channel layer 132m is a layer that forms a channel between the main source electrode 173m and the main drain electrode 175m, and a 2-dimensional electron gas (2DEG) 134 may be positioned inside the main channel layer 132m. The 2-dimensional electron gas 134 is a charge transport model used in solid physics, and refers to a group of electrons that can move freely in 2 dimensions (e.g., a x-y planar direction) but cannot move in another dimension (e.g., a direction Z) and are tightly bound within a 2-dimensional space. In other words, the 2-dimensional electron gas 134 may exist in a 2-dimensional paper-like form within a 3-dimensional space. This 2-dimensional electron gas 134 mainly appears in a semiconductor heterojunction structure, and may occur at the interface between the main channel layer 132m and the main barrier layer 136m in the semiconductor device according to an embodiment. For example, two-dimensional electron gas 134 may be generated in the area adjacent to the main barrier layer 136m within the main channel layer 132m. In an embodiment, the main channel layer 132m may refer to the portion of the channel layer 132 positioned in the main element area MA.

The main channel layer 132m may include one or more materials selected from Group III-V materials, such as nitrides including Al, Ga, In, B, or combinations thereof. The main channel layer 132m may be composed of a single layer or multiple layers. The main channel layer 132m may be AlₓIn_{y}Ga_{(1-x-y)}N (0≤x≤1, 0≤y≤1, x+y≤1). For example, the main channel layer 132m may include AIN, GaN, InN, InGaN, AlGaN, AllnN, AllnGaN, or a combination thereof. The main channel layer 132m may be a layer with a doped impurity or a layer with an undoped impurity. The thickness of the main channel layer 132m may be about several hundred nm or less.

The main channel layer 132m may be positioned on the substrate 110, and a seed layer 121 and a buffer layer 120 may be positioned between the substrate 110 and the main channel layer 132m. The substrate 110, the seed layer 121, and the buffer layer 120 are layers desired to form the main channel layer 132m, and may be omitted in some cases. For example, when using a substrate made of GaN as the main channel layer 132m, at least one of the substrate 110, the seed layer 121, or the buffer layer 120 may be omitted. Considering that the price of a substrate made of GaN is relatively high, the main channel layer 132m including GaN may be grown using the substrate 110 made of Si. At this time, as a lattice structure of Si and a lattice structure of GaN are different, it may not be easy to grow the main channel layer 132m directly on the substrate 110. Accordingly, after growing the seed layer 121 and the buffer layer 120 on the substrate 110 first, the main channel layer 132m may be grown on the buffer layer 120. Additionally, at least one of the substrate 110, the seed layer 121, or the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a SOI (Silicon on Insulator) substrate. However, the material of the substrate 110 is not limited to this, and any generally-used substrate may be applied. In some cases, the substrate 110 may include an insulating material. For example, after forming first several layers, including the main channel layer 132m, on the semiconductor substrate, then the semiconductor substrate may be removed to be replaced with an insulation substrate.

The seed layer 121 may be positioned directly above the substrate 110. However, embodiments are not limited to this, and another desired (or predetermined) layer may be further positioned between the substrate 110 and the seed layer 121. The seed layer 121 is a layer that serves as a seed for growing the buffer layer 120, and may be made of a crystal lattice structure that becomes the seed of the buffer layer 120. The buffer layer 120 may be positioned directly above the seed layer 121. However, embodiments are not limited to this, and another desired (or predetermined) layer may be positioned between the seed layer 121 and the buffer layer 120. The seed layer 121 may include one or more materials selected from Group III-V materials, such as nitrides including Al, Ga, In, B, or combinations thereof. The seed layer 121 may be AlₓIn_{y}Ga_{(1-x-y)}N (0≤x≤1, 0≤y≤1, x+y≤1). For example, the seed layer 121 may be AIN, GaN, InN, InGaN, AlGaN, AllnN, AllnGaN, or a combination thereof.

The buffer layer 120 may be positioned above the seed layer 121. The buffer layer 120 may be positioned between the seed layer 121 and the main channel layer 132m. The buffer layer 120 may be a layer to alleviate the difference in a lattice constant and a thermal expansion coefficient between the seed layer 121 and the main channel layer 132m, or to reduce or prevent a parasitic current (a leakage current) from flowing through the main channel layer 132m. The buffer layer 120 may include one or more materials selected from Group III-V materials, such as nitrides including Al, Ga, In, B, or combinations thereof. The buffer layer 120 may be AlₓIn_{y}Ga_{(1-x-y)}N (0≤x≤1, 0≤y≤1, x+y≤1). For example, the buffer layer 120 may be AIN, GaN, InN, InGaN, AlGaN, AllnN, AllnGaN, or a combination thereof.

The buffer layer 120 of the semiconductor device according to an embodiment may include a superlattice layer 124 positioned above the seed layer 121, and a high resistance layer 126 positioned above the superlattice layer 124. The superlattice layer 124 and the high-resistance layer 126 may be positioned sequentially on the substrate 110.

The superlattice layer 124 may be positioned above the seed layer 121. The superlattice layer 124 may be positioned directly above the seed layer 121. However, embodiments are not limited to this, and another desired (or predetermined) layer may be positioned between the seed layer 121 and the superlattice layer 124. The superlattice layer 124 alleviates the difference in a lattice constant and a thermal expansion coefficient between the substrate 110 and the main channel layer 132m, thereby reducing a tensile stress and a compressive stress generated between the substrate 110 and the main channel layer 132m, and is a layer to relieve a stress between entire layers formed by a growth in the final structure of the semiconductor device according to an embodiment. The superlattice layer 124 may include one or more materials selected from Group III-V materials, such as nitrides including Al, Ga, In, B, or combinations thereof. The superlattice layer 124 may be AlₓIn_{y}Ga_{(1-x-y)}N (0≤x≤1, 0≤y≤1, x+y≤1). For example, the superlattice layer 124 may be AIN, GaN, InN, InGaN, AlGaN, AllnN, AllnGaN, or a combination thereof.

In an embodiment, the superlattice layer 124 may be comprised of multiple layers of alternating layers including different materials. For example, the superlattice layer 124 may have a structure in which a layer made of AlGaN and a layer made of AIN are repeatedly stacked

That is, AIGaN/AIN/AIGaN/AIN/AIGaN/AIN may be sequentially stacked to form a superlattice layer. The number of AlGaN layers and AIN that make up the superlattice layer 124 may be changed in various ways, and the material that makes up the superlattice layer 124 may be changed in various ways. As another example, the superlattice layer may have a structure in which a layer made of AlGaN and a layer made of GaN are repeatedly stacked. That is, AIGaN/GaN/AIGaN/GaN/AIGaN/GaN may be sequentially stacked to form a superlattice layer. In an embodiment, when the superlattice layer 124 includes GaN, InN, AlGaN, AllnN, InGaN, AIN, AllnGaN or a combination thereof, the superlattice layer 124 may have an N-type semiconductor characteristic in which the concentration of electrons is greater than the concentration of holes, but embodiments are not limited thereto.

The high resistance layer 126 may be positioned above the superlattice layer 124. The high resistance layer 126 may be positioned directly above the superlattice layer 124. However, embodiments are not limited to this, and other desired (or predetermined) layers may be positioned between the superlattice layer 124 and the high resistance layer 126. The high resistance layer 126 may be positioned between the superlattice layer 124 and the main channel layer 132m. The high resistance layer 126 is a layer to mitigate or prevent the semiconductor device according to an embodiment from being degraded by preventing a leakage current from flowing through the main channel layer 132m. The high resistance layer 126 may be made of a material with low conductivity so that it may be electrically insulated between the substrate 110 and the main channel layer 132m. The high resistance layer may include one or more materials selected from Group III-V materials, such as nitrides including Al, Ga, In, B, or combinations thereof. The high resistance layer 126 may be AlₓIn_{y}Ga_{(1-x-y)}N (0≤x≤1, 0≤y≤1, x+y≤1). For example, the high resistance layer 126 may be AIN, GaN, InN, InGaN, AlGaN, AllnN, AllnGaN, or a combination thereof. The high resistance layer 126 may be made of a single layer or multiple layers. In an embodiment, when the high resistance layer 126 includes GaN, InN, AlGaN, AllnN, InGaN, AIN, AllnGaN or a combination thereof, the high resistance layer 126 may have an N-type semiconductor characteristic in which the concentration of electrons is greater than the concentration of holes, but embodiments are not limited thereto.

The main barrier layer 136m may be positioned above the main channel layer 132m. The main barrier layer 136m may be positioned directly above the main channel layer 132m. However, embodiments are not limited to this, and another desired (or predetermined) layer may be positioned between the main channel layer 132m and the main barrier layer 136m. The area of the main channel layer 132m that overlaps the main barrier layer 136m between the main source electrode 173m and the main drain electrode 175m may be a main drift area DTRm. The main drift area DTRm may be positioned between the main source electrode 173m and the main drain electrode 175m. The main drift area DTRm may mean an area to which or through which a carrier moves when a potential difference occurs between the main source electrode 173m and the main drain electrode 175m.

The semiconductor device according to an embodiment may be turned on/off depending on whether a voltage is applied to the main gate electrode 155m and/or the magnitude of the voltage applied to the main gate electrode 155m, and accordingly, the movement of the carrier may occur in the first drift area DTR1 or may be blocked.

The main barrier layer 136m may include one or more materials selected from Group III-V materials, such as nitrides including Al, Ga, In, B, or combinations thereof. The main barrier layer 136m may be AlₓIn_{y}Ga_{(1-x-y)}N (0≤x≤1, 0≤y≤1, x+y≤1). The main barrier layer 136m may include GaN, InN, AlGaN, AllnN, InGaN, AIN, AllnGaN or combination thereof. The energy band gap of the main barrier layer 136m may be adjusted by a composition ratio of Al and/or In. The main barrier layer 136m may be doped with a desired (or predetermined) impurity. At this time, the impurity doped in the main barrier layer 136m may be a P-type dopant that may provide a hole. For example, the impurity doped in the main barrier layer 136m may be magnesium (Mg). By increasing or lowering the impurity doping concentration of the main barrier layer 136m, the threshold voltage, on-resistance, etc. of the semiconductor device according to an embodiment may be adjusted.

The main barrier layer 136m may include a semiconductor material with different characteristics from the main channel layer 132m. The main barrier layer 136m may differ from the main channel layer 132m in at least one of polarization characteristic, energy band gap, or lattice constant. For example, the main barrier layer 136m may include a material with a different energy band gap than the main channel layer 132m. At this time, the main barrier layer 136m may have a higher energy band gap than the main channel layer 132m and may have a higher electrical polarization than the main channel layer 132m. This main barrier layer 136m may cause a 2-dimensional electron gas 134 in the main channel layer 132m, which has a relatively low electrical polarization rate. In this regard, the main barrier layer 136m may also be called a channel supply layer or a 2-dimensional electron gas supply layer. The 2-dimensional electron gas 134 may be formed within a portion of the main channel layer 132m positioned below the interface between the main channel layer 132m and the main barrier layer 136m. The 2-dimensional electron gas 134 may have very high electron mobility.

The main barrier layer 136m may be made of a single layer or multiple layers. The main barrier layer 136m is made of multiple layers, the energy band gap of the material of each layer constituting the multiple layers may be different. At this time, the multiple layers constituting the main barrier layer 136m may be arranged so that the energy band gap increases as it approaches the main channel layer 132m.

The main gate electrode 155m may be positioned above the main barrier layer 136m. The main gate electrode 155m may overlap a portion of the main barrier layer 136m in the vertical direction (e.g., in a thickness direction of the main channel layer 132m). The main gate electrode 155m may overlap a portion of the main drift area DTRm of the main channel layer 132m in the vertical direction (e.g., the thickness direction of the main channel layer 132m). The main gate electrode 155m may be positioned between the main source electrode 173m and the main drain electrode 175m. The main gate electrode 155m may be separated from the main source electrode 173m and the main drain electrode 175m. For example, the main gate electrode 155m can be positioned closer to the main source electrode 173m than to the main drain electrode 175m. In other words, the separation distance between the main gate electrode 155m and the main source electrode 173m may be smaller than the separation distance between the main gate electrode 155m and the main drain electrode 175m, but embodiments are not limited thereto. In an embodiment, the main gate electrode 155m may refer to the gate electrode portion positioned in the main element area MA.

In an embodiment, the main gate electrode 155m may be electrically connected to word line WL to apply the gate signal. Accordingly, the gate signals may be applied to the main gate electrode 155m. For example, in the first mode, a first gate voltage may be applied to the main gate electrode 155m, and in second mode, a second gate voltage greater than the first gate voltage may be applied to the main gate electrode 155m. However, embodiments are not limited thereto, the second gate voltage need not be applied to the main gate electrode 155m.

The main gate electrode 155m may include a conductive material. For example, the main gate electrode 155m may include metal, metal alloy, conductive metal nitride, metal silicide, a doped semiconductor material, conductive metal oxide, or conductive metal oxynitride. For example, the main gate electrode 155m may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonizationnitride (TiAIC-N) (titanium aluminium carbonitride), titanium aluminum carbide (TiAIC), titanium carbide (TiC), tantalum carbonizationnitride (TaCN) (tantalum carbonitride), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride(NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combination thereof, but embodiments are not limited thereto. The main gate electrode 155m may be made of a single layer or multiple layers.

The gate semiconductor layer 152 may be positioned between the main barrier layer 136m and the main gate electrode 155m. That is, the gate semiconductor layer 152 may be positioned above the main barrier layer 136m, and the main gate electrode 155m may be positioned above the gate semiconductor layer 152. The main gate electrode 155m may form a Schottky contact or an ohmic contact with the gate semiconductor layer 152. The gate semiconductor layer 152 may overlap the main gate electrode 155m in the vertical direction (e.g., the thickness direction of the main channel layer 132m). At this time, the gate semiconductor layer 152 may completely overlap the main gate electrode 155m in the vertical direction (e.g., the thickness direction of the main channel layer 132m), and the upper surface of the gate semiconductor layer 152 is entirely covered by the main gate electrode 155m. That is, the gate semiconductor layer 152 may have the same or substantially similar planar shape as the main gate electrode 155m. However, embodiments are not limited thereto, the main gate electrode 155m may be positioned to cover at least part of the gate semiconductor layer 152.

The gate semiconductor layer 152 may be positioned between the main source electrode 173m and the main drain electrode 175m. The gate semiconductor layer 152 may be separated from the main source electrode 173m and the main drain electrode 175m. The gate semiconductor layer 152 may be positioned closer to the main source electrode 173m than to the main drain electrode 175m. In other words, the separation distance between the gate semiconductor layer 152 and the main source electrode 173m may be smaller than the separation distance between the gate semiconductor layer 152 and the main drain electrode 175m, but embodiments are not limited thereto.

In an embodiment, the gate semiconductor layer 152 may overlap the main gate electrode 155m in the vertical direction (e.g., the thickness direction of the main channel layer 132m). For example, the gate semiconductor layer 152 may completely overlap the main gate electrode 155m in the vertical direction (e.g., the thickness direction of the main channel layer 132m). That is, the side of the gate semiconductor layer 152 may be aligned with the side of the main gate electrode 155m. However, embodiments are not limited thereto, the gate semiconductor layer 152 may partially overlap the main gate electrode 155m.

The gate semiconductor layer 152 may include one or more materials selected from Group III-V materials, such as nitrides including Al, Ga, In, B, or combinations thereof. The gate semiconductor layer 152 may be AlₓIn_{y}Ga_{(1-x-y)}N (0≤x≤1, 0≤y≤1, x+y≤1). For example, the gate semiconductor layer 152 may be AIN, GaN, InN, InGaN, AlGaN, AllnN, AllnGaN, or a combination thereof. The gate semiconductor layer 152 may include a material with a different energy band gap than the main barrier layer 136m. For example, the gate semiconductor layer 152 may include GaN, and the main barrier layer 136m may include AlGaN. The gate semiconductor layer 152 may be doped to a desired (or predetermined) impurity. At this time, the impurity doped in the gate semiconductor layer 152 may be a P-type dopant that may provide a hole. For example, the gate semiconductor layer 152 may include GaN doped with a P-type impurity. That is, the gate semiconductor layer 152 may be made of a p-GaN layer. However, embodiments are not limited to this, and the gate semiconductor layer 152 may be a p-AlGaN layer. The gate semiconductor layer 152 may be made of a single layer or multiple layers.

A depletion area DPR may be formed within 132m of the main channel layer by the gate semiconductor layer 152. The depletion area DPR may be positioned within the main drift area DTRm and have a narrower width than the main drift area DTRm. As the gate semiconductor layer 152, which has the different energy band gap from that of the main barrier layer 136m, is positioned on the main barrier layer 136m, the level of the energy band of the portion of the barrier layer 136 that overlaps the gate semiconductor layer 152 may increase. Accordingly, the depletion region DPR may be formed in the region of the main channel layer 132m that overlaps the gate semiconductor layer 152. The depletion region DPR may be a region in the channel path of the main channel layer 132m. In the depletion region DPR, the 2-dimensional electron gas 134 is not formed or has a lower electron concentration than the remaining regions. In other words, the depletion region DPR may mean a region where the flow of the 2-dimensional electron gas 134 is disconnected. As the depletion area DPR occurs, a current does not flow between the main source electrode 173m and the main drain electrode 175m, and the channel path may be blocked. Accordingly, the semiconductor device according to an embodiment may have a normally off characteristic.

That is, the semiconductor device according to an embodiment may be a normally off high electron mobility transistor (HEMT). As shown in FIG. 4, in a normal state in which no voltage is applied to the main gate electrode 155m, the depletion region DPR exists, and the semiconductor device according to an embodiment may be in an off state. As shown in FIG. 5, when a voltage higher than a threshold voltage is applied to the main gate electrode 155m, the depletion region DPR disappears, and the 2-dimensional electron gas 134 within the drift region DTR is not disconnected and may be connected. That is, the 2-dimensional electron gas 134 may be formed throughout the channel path between the main source electrode 173m and the main drain electrode 175m, and the semiconductor device according to an embodiment may be in an on state. In summary, the semiconductor device according to an embodiment may include the semiconductor layers with different electrical polarization characteristics, the semiconductor layer with the relatively high polarization rate may induce the 2-dimensional electron gas 134 in another semiconductor layer heterogeneously jointed thereto. This 2-dimensional electron gas 134 may be used as a channel between the main source electrode 173m and the main drain electrode 175m, and the connection or disconnection of the flow of this 2-dimensional electron gas 134 may be controlled by the bias voltage applied to the main gate electrode 155m. In the gate off state, the flow of the 2-dimensional electron gas 134 is blocked, so a current need not flow between the main source electrode 173m and the main drain electrode 175m. As the flow of the 2-dimensional electron gas 134 continues in the gate on state, a current may flow between the main source electrode 173m and the main drain electrode 175m.

In the above, the case where the semiconductor device according to an embodiment is a normally off high electron mobility transistor has been described, but embodiments are not limited thereto. For example, the semiconductor device according to an embodiment may be a normally-on high electron mobility transistor. In the case of the normally on high electron mobility transistor, the gate semiconductor layer 152 may be omitted, and thus the main gate electrode 155m may be positioned directly above the main barrier layer 136m. In other words, the main gate electrode 155m may be in contact with the main barrier layer 136m. In this structure, the two-dimensional electron gas 134 may be used as a channel without a voltage being applied to the main gate electrode 155m, and a current flow may occur between the main source electrode 173m and the main drain electrode 175m. Additionally, when a negative voltage is applied to the main gate electrode 155m, a depletion area (DPR) in which the flow of the 2-dimensional electron gas 134 is cut off may occur at the lower portion of the main gate electrode 155m.

The previously described seed layer 121, superlattice layer 124, high-resistance layer 126, main channel layer 132m, main barrier layer 136m, and gate semiconductor layer 152 may be sequentially stacked on the substrate 110. In the semiconductor device according to an embodiment, at least one of the seed layer 121, superlattice layer 124, high resistance layer 126, main channel layer 132m, main barrier layer 136m, or gate semiconductor layer 152 may be omitted. The seed layer 121, the superlattice layer 124, the high resistance layer 126, the main channel layer 132m, the main barrier layer 136m, and the gate semiconductor layer 152 may be made of the same base semiconductor material(s), and by considering the role of each layer and the performance desired for the semiconductor device, etc., a material composition ratio of each layer may be different.

The protection layers 140 and 180 may be positioned above the main barrier layer 136m and the main gate electrode 155m. The protection layers 140 and 180 may include a first protection layer 140 covering the main barrier layer 136m and the main gate electrode 155m, and a second protection layer 180 positioned above the first protection layer 140.

The first protection layer 140 may be positioned above the main barrier layer 136m and the main gate electrode 155m. The first protection layer 140 may cover the upper and side surfaces of the main gate electrode 155m and the side surface of the gate semiconductor layer 152. The bottom surface of the first protection layer 140 may be in contact with the main barrier layer 136m and the main gate electrode 155m. Accordingly, the main barrier layer 136m, gate semiconductor layer 152, and main gate electrode 155m may be protected by the first protection layer 140. However, embodiments are not limited thereto, the main gate electrode 155m may penetrate the first protection layer 140 and be connected to the gate semiconductor layer 152, and the first protection layer 140 need not cover the upper surface of the main gate electrode 155m. In some embodiments, the bottom surface of the first protection layer 140 may be in contact with the gate semiconductor layer 152. The first protection layer 140 may include an insulating material. For example, the first protection layer 140 may include oxide such as SiOz or Al₂O₃. As another example, the first protection layer 140 may include nitride such as SiN or oxynitride such as SiON.

The second protection layer 180 may be positioned above the first protection layer 140, the main drain electrode 175m, and the main source electrode 173m. The second protection layer 180 may cover the gate semiconductor layer 152 and the main gate electrode 155m. The second protection layer 180 may include a trench exposing at least a portion of the main drain electrode 175m and the main source electrode 173m, but embodiments are not limited thereto. Through the trenches of the second protection layer 180, the main drain electrode 175m and/or the main source electrode 173m may be electrically connected to a desired (or predetermined) wiring (e.g., a second voltage line VL2). The second protection layer 180 may include an insulating material. The second protection layer 180 may include the same material as the first protection layer 140, but embodiments are not limited thereto. In some embodiments, it may further include a contact electrode electrically connected to the main drain electrode 175m and/or the main source electrode 173m by passing through the second protection layer 180.

In FIG. 4 and FIG. 5, the protection layers 140 and 180 are shown as consisting of a single layer, but embodiments are not limited thereto, the protection layers 140 and 180 may be comprised of multiple layers including different materials.

The main source electrode 173m and the main drain electrode 175m may be positioned above the main channel layer 132m. The main source electrode 173m and the main drain electrode 175m may be in directly contact with the main channel layer 132m and be electrically connected to the main channel layer 132m.

In an embodiment, main drain electrode 175m can be electrically connected to second voltage line VL2, which supplies a second power voltage. Accordingly, the second power voltage may be supplied to the main drain electrode 175m through the second voltage line VL2.

The main source electrode 173m and the main drain electrode 175m may be extended in the second direction (the direction Y). The main source electrode 173m and the main drain electrode 175m may be spaced apart from each other, and the main gate electrode 155m and the gate semiconductor layer 152 may be positioned between the main source electrode 173m and the main drain electrode 175m. The main gate electrode 155m and the gate semiconductor layer 152 may be separated from the main source electrode 173m and the main drain electrode 175m. For example, the main source electrode 173m may be electrically connected to the main channel layer 132m on one side of the main gate electrode 155m, and the main drain electrode 175m may be electrically connected to the main channel layer 132m on the other side of the main gate electrode 155m. The main source electrode 173m and the main drain electrode 175m may be positioned outside the main drift area DTRm of the main channel layer 132m. The interface between the main source electrode 173m and the main channel layer 132m may be one edge of the main drift area DTRm. Likewise, the interface between the main drain electrode 175m and the main channel layer 132m may be the other edge of the main drift area DTRm.

However, embodiments are not limited to this, and the main source electrode 173m and the main drain electrode 175m need not be positioned on the exterior side of the main drift area DTRm of the main channel layer 132m. That is, the main channel layer 132m need not be recessed, and the main source electrode 173m and the main drain electrode 175m may be positioned on the upper surface of the main channel layer 132m. In this case, the bottom surface of the main source electrode 173m and the main drain electrode 175m may be in contact with the upper surface of the main channel layer 132m. The part of the main channel layer 132m in contact with the main source electrode 173m and the main drain electrode 175m may be doped with high concentration. At this time, the carrier passing through the two-dimensional electron gas 134 may pass through the portion of the main channel layer 132m doped at high concentration (e.g., the upper part of the two-dimensional electron gas 134), and may be transmitted to the main source electrode 173m and the main drain electrode 175m. The main source electrode 173m and the main drain electrode 175m need not be in direct contact with the two-dimensional electron gas 134 in the horizontal direction. Here, the horizontal direction may mean a direction parallel to the upper surface of the main channel layer 132m or the main barrier layer 136m.

Specifically, a trench that penetrates the first protection layer 140 and the main barrier layer 136m and recesses the upper surface of the main channel layer 132m may be positioned to be spaced apart from each other on both sides of the main gate electrode 155m. The main source electrode 173m and the main drain electrode of 175m each may be positioned in the trench positioned on a corresponding side of the main gate electrode of 155m. The main source electrode 173m and the main drain electrode 175m may be formed to fill the trench. Within the trench, the main source electrode 173m and the main drain electrode 175m may be in contact with the main channel layer 132m and the main barrier layer 136m. The main channel layer of 132m may form the bottom surface and side wall of the trench, and the main barrier layer 136m may form the side wall of the trench. Therefore, the main source electrode 173m and the main drain electrode 175m may be in contact with the upper and side surfaces of the main channel layer 132m. Additionally, the main source electrode 173m and the main drain electrode 175m may be in contact with the side surface of the main barrier layer 136m. That is, the main source electrode 173m and the main drain electrode 175m may cover the sides of the main channel layer 132m and the main barrier layer 136m.

In an embodiment, the main source electrode 173m and the main drain electrode 175m may cover at least a portion of the side surface of the first protection layer 140. For example, the main source electrode 173m and the main drain electrode 175m may cover the sides of the first protection layer 140. The upper surface of the main source electrode 173m and the main drain electrode 175m may protrude from the upper surface of first protection layer 140. Additionally, at least one of the main source electrode 173m or the main drain electrode 175m may cover at least a portion of the upper surface of the first protection layer 140. However, embodiments are not limited thereto, the main source electrode 173m and the main drain electrode 175m may cover at least part of the side of the first protection layer 140 and need not cover the remaining part of the side of the first protection layer 140. In this case, the remaining part of the first protection layer 140 may be positioned on the upper surface of the main source electrode 173m and the main drain electrode 175m.

The main source electrode 173m and the main drain electrode 175m may include a conductive material. For example, the main source electrode 173m and the main drain electrode 175m may include metal, a metal alloy, conductive metal nitride, metal silicide, a doped semiconductor material, conductive metal oxide, or conductive metal oxynitride. For example, the main source electrode 173m and the main drain electrode 175m may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonizationnitride (TiAIC-N) (titanium aluminium carbonitrode), titanium aluminum carbide (TiAIC), titanium carbide (TiC), tantalum carbonizationnitride (TaCN) (tantalumcarbonitride), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combination thereof, but embodiments are not limited thereto. The main source electrode 173m and the main drain electrode 175m may be made of a single layer or multiple layers. The main source electrode 173m and the main drain electrode 175m may be in ohmic contact with the main channel layer 132m. The region within the main channel layer 132m that is in contact with the main source electrode 173m and the main drain electrode 175m may be doped at a relatively high concentration compared to other regions.

In FIG. 4 and FIG. 5, the semiconductor device according to an embodiment is shown as including a pair of main source electrode 173m and main drain electrode 175m, but the number of main source electrode 173m and main drain electrode 175m is not limited thereto. For example, the main source electrode 173m may include a plurality of source electrodes sequentially stacked in the vertical direction (e.g., the thickness direction of the main channel layer 132m) on the main channel layer 132m, and the main drain electrode 175m may also include a plurality of drain electrodes sequentially stacked in the vertical direction (e.g., the thickness direction of the main channel layer 132m) over the main channel layer 132m. At this time, the plurality of source electrodes and the plurality of drain electrodes may penetrate the second protection layer 180. In some embodiments, each of the main source electrode 173m and the main drain electrode 175m may include three or more layers.

Although not shown in the drawings, a semiconductor device according to an embodiment may further include a field dispersed layer covering at least a portion of the protective layer 140.

The field dispersed layer may be positioned between the main source electrode 173m and the main drain electrode 175m. The field dispersed layer may cover the main gate electrode155m. The field dispersed layer may overlap the main gate electrode 155m in the vertical direction (e.g., the thickness direction of the main channel layer 132m). The field dispersed layer may be electrically connected to the main source electrode 173m. For example, the field dispersed layer may be connected to the main source electrode 173m. The field dispersed layer may include the same material as the main source electrode 173m and may be positioned in the same layer as the main source electrode 173m. The field dispersed layer may be formed simultaneously in the same process as the main source electrode 173m. In other words, the boundary between the field dispersed layer and the main source electrode 173m is not clear, and the field dispersed layer may be formed integrally with the main source electrode 173m. However, embodiments are not limited to this, and the field dispersed layer may be a separate component from the main source electrode 173m. Additionally, the field disperse layer may be positioned in a different layer from the main source electrode 173m and may be formed in a different process.

The field dispersed layer may serve to disperse the electric field concentrated around the main gate electrode 155m. For example, in the gate off state, the 2-dimensional electron gas 134 may be positioned with very high concentration in the part of the main channel layer 132m positioned between the main gate electrode 155m and the main source electrode 173m and in the part of the main channel layer 132m positioned between the main gate electrode 155m and the main drain electrode 175m. In this case, an electric field may be concentrated on the main gate electrode 155m or the gate semiconductor layer 152. Meanwhile, the main gate electrode 155m and the gate semiconductor layer 152 are vulnerable to an electric field, so when the electric field is concentrated, a leakage current may increase and the breakdown voltage of the main transistor MTR may decrease. At this time, the electric field concentrated around the main gate electrode 155m or the gate semiconductor layer 152 may be dispersed by the field disperse layer, so the leakage current may be reduced and the breakdown voltage may be increased.

Hereinafter, peripheral circuit elements of the semiconductor device according to an embodiment will be described further with reference to FIG. 3 and FIG. 6 to FIG. 8.

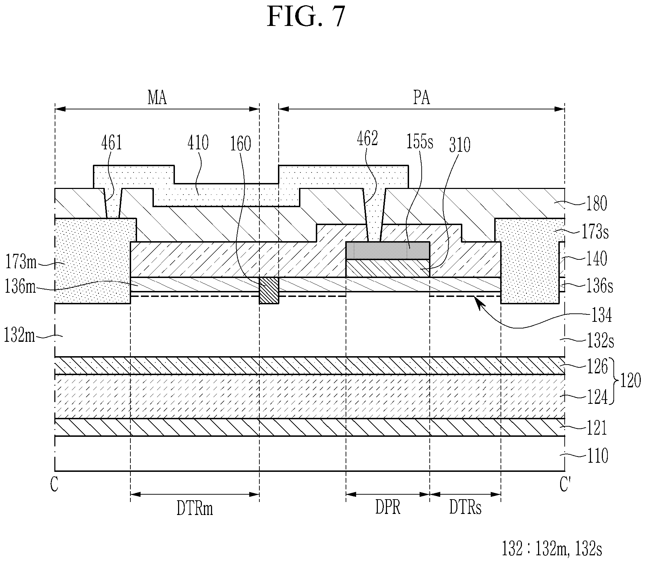

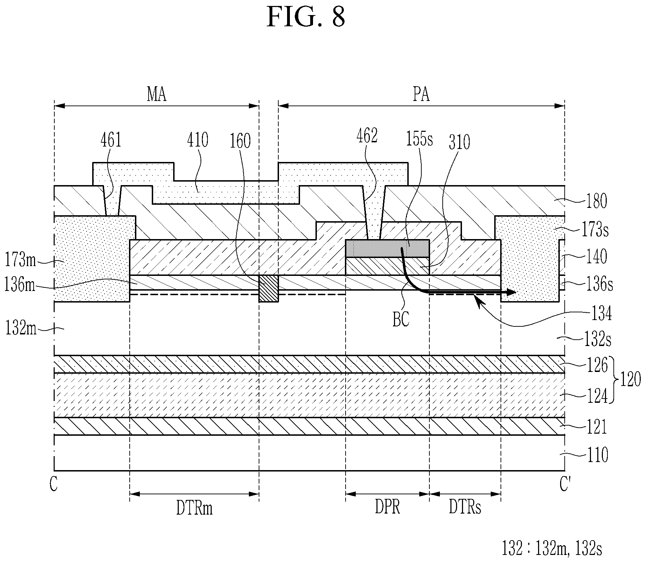

FIG. 6 is a cross-sectional view taken along a line B-B' in FIG. 3. FIG. 7 is a cross-sectional view taken along a line C-C' in FIG. 3. FIG. 8 is a cross-sectional view taken along a line C-C' in FIG. 3 and showing a current path formed in an anti-fuse of a semiconductor device according to an embodiment.

First, referring to FIG. 3, an anti-fuse AF of a semiconductor device according to an embodiment may be positioned on one side of the main transistor MTR. For example, the peripheral circuit area PA may be positioned away from the main element area MA in the second direction (the direction Y), but embodiments are not limited thereto. As another example, the peripheral circuit area PA may be positioned away from the main element area MA in the first direction (the direction X), or may surround the side of the main element area MA. At this time, the separation structure 160 may be positioned between peripheral circuit area PA and the main element area MA, but embodiments are not limited thereto.

In an embodiment, the anti-fuse AF may have a smaller area than the main transistor MTR. For example, the width of anti-fuse AF along the second direction (the direction Y) may be less than or equal to the width of the main transistor MTR along the second direction (the direction Y). Additionally, the width of the anti-fuse AF along the first direction (the direction X) may be less than or equal to the width of the main transistor MTR along the first direction (the direction X). However, embodiments are not limited thereto, the anti-fuse AF may have the same or substantially similar area as or the larger area than the main transistor MTR.

Further referring to FIG. 6 and FIG. 7, an anti-fuse AF of a semiconductor device according to an embodiment may include a sub-channel layer 132s including a sub-drift area DTRs with two-dimensional electron gas, a sub-barrier layer 136s placed on the sub-channel layer 132s, a sub-gate electrode 155s placed on the sub-barrier layer 136s, a gate semiconductor pattern 310 placed between the sub-barrier layer 136s and the sub-gate electrode 155s, a sub-source electrode 173s placed on the sub-channel layer 132s, and a first connection wiring 410 electrically connecting the main source electrode 173m and the sub-gate electrode 155s.

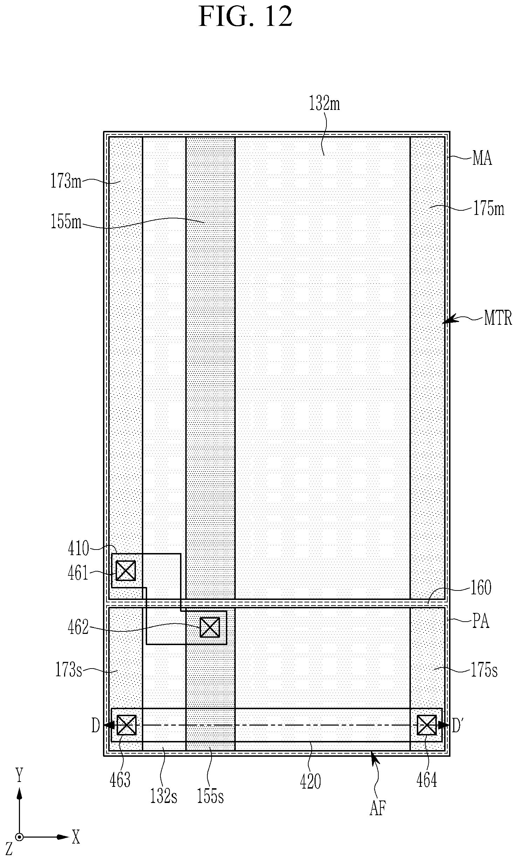

The sub-channel layer 132s may be positioned on the substrate 110. The sub-channel layer 132s is a layer that forms a channel between the sub-source electrode 173s and the sub-gate semiconductor pattern 310 and a 2-dimensional electron gas (2DEG) 134 may be positioned inside the sub-channel layer 132s. The 2-dimensional electron gas 134 may occur at the interface between the sub-channel layer 132s and the sub-barrier layer 136s in the semiconductor device according to an embodiment. For example, the 2-dimensional electron gas 134 may be generated in the area adjacent to the sub-barrier layer 136s within the sub-channel layer 132s. However, embodiments are not limited thereto, the sub-channel layer 132s may be a layer that forms a channel between the sub-source electrode 173s and the sub-drain electrode (175s in FIG. 12). The explanation of this will be described later with reference to FIGS. 11-14. In an embodiment, the sub-channel layer 132s may refer to a portion of the channel layer 132 that is positioned in the peripheral circuit area PA and constitutes the channel of the anti-fuse AF.

In an embodiment, the sub-channel layer 132s may be integrally formed by the same process as the main channel layer 132m of the main transistor MTR. The sub-channel layer 132s may be positioned on the same layer as the main channel layer 132m. The bottom surface of the sub-channel layer 132s may be positioned at the same level as the bottom surface of the main channel layer 132m, and the upper surface of the sub-channel layer 132s may be positioned at the same level as the upper surface of the main channel layer 132m. That is, the bottom surface of the sub-channel layer 132s and the bottom surface of the main channel layer 132m may be positioned at the same distance from the upper surface of the substrate 110. Additionally, the top surface of the sub-channel layer 132s and the top surface of the main channel layer 132m may be positioned at the same distance from the upper surface of the substrate 110. The thickness of the sub-channel layer 132s along the third direction (the direction Z) may be the same as or substantially similar to the thickness of the main channel layer 132m along the third direction (the direction Z), but embodiments are not limited thereto. At this time, the sub-channel layer 132s and the main channel layer 132m may be separated by a separation structure 160, which will be explained later.

In an embodiment, the sub-channel layer 132s may be positioned on one side of the main channel layer 132m. For example, the sub-channel layer 132s may be positioned on one side of the main channel layer 132m along the second direction (the direction Y), but embodiments are not limited thereto. At this time, the width of the sub-channel layer 132s along the second direction (the direction Y) may be different from the width of the main channel layer 132m along the second direction (the direction Y). For example, the width of the sub-channel layer 132s along the second direction (the direction Y) may be smaller than the width of the main channel layer 132m along the second direction (the direction Y).

In an embodiment, the sub-channel layer 132s may include the same material as the main channel layer 132m positioned in the main element area MA. For example, the sub-channel layer 132s may include one or more materials selected from Group III-V materials, such as nitrides including Al, Ga, In, B, or combinations thereof.

The sub-channel layer 132s may be positioned on the substrate 110, and the seed layer 121 and the buffer layer 120 may be positioned between the substrate 110 and the sub-channel layer 132s. The substrate 110, the seed layer 121, and the buffer layer 120 are layers desired to form the sub-channel layer 132s and may be omitted in some cases. In an embodiment, the substrate 110, the seed layer 121, and the buffer layer 120 positioned in the peripheral circuit area PA may be integrally formed by the same process as the substrate 110, the seed layer 121, and the buffer layer 120 positioned in the main element area MA, respectively.

The sub-barrier layer 136s may be positioned above the sub-channel layer 132s. The sub-barrier layer 136s may be positioned directly above the sub-channel layer 132s. However, embodiments are not limited to this, and another desired (or predetermined) layer may be positioned between the sub-channel layer 132s and the sub-barrier layer 136s. The area of the sub-channel layer 132s that overlaps the sub-barrier layer 136s may be a drift area. For example, the sub-barrier layer 136s is different from the sub-channel layer 132s in at least one of the polarization characteristic, energy band gap, or lattice constant, the 2-dimensional electron gas 134 may be induced in the sub-channel layer 132s, which has the relatively low electrical polarization rate, by the sub-barrier layer 136s.

In an embodiment, the sub-barrier layer 136s may extend in the first direction (the X direction). The length that the sub-barrier layer 136s extends in the first direction (the direction X) may be shorter than the length that the main barrier layer 136m extends in the first direction (the direction X). At this time, the separation structure 160 may be positioned in the portion where the sub-barrier layer 136s is not positioned. That is, as shown in FIG. 3, the sub-barrier layer 136s may be positioned in at least part of the peripheral circuit area PA of the semiconductor device according to an embodiment, and the separation structure 160 may be positioned in the remaining part. However, embodiments are not limited thereto, the length at which the sub-barrier layer 136s extends in the first direction (the direction X) may be the same as or substantially similar to the length at which the main barrier layer 136m extends in the first direction (the direction X). The explanation of this will be described later with reference to FIG. 11 to FIG. 13.

As shown in FIG. 6 and FIG. 7, in the peripheral circuit area PA, the sub-channel layer 132s may include the sub-drift area DTRs between the sub-gate electrode 155s and the sub-source electrode 173s. In other words, the sub-drift area DTRs may mean the area of the sub-channel layer 132s from one side of the sub-channel layer 132s in contact with the sub-source electrode 173s to the sub-gate electrode 155s. The sub-drift area DTRs may refer to the area of the sub-channel layer 132s that overlaps the main barrier layer 136m between the sub-gate electrode 155s and the sub-source electrode 173s. For example, the boundary where the sub-source electrode 173s and the sub-channel layer 132s meet may be one edge of the sub-drift area DTRs, and the boundary where the sub-gate electrode 155s and the sub-channel layer 132s meet may be the other edge of the sub-drift area DTRs. In other words, the sub-drift area DTRs may mean an area where carriers move between one side of the sub-channel layer 132s in contact with the sub-source electrode 173s and the sub-gate electrode 155s within the peripheral circuit area PA. In an embodiment, the sub-drift area DTRs may extend in the first direction (the direction X) of the sub-channel layer 132s, but embodiments are not limited thereto.

The sub-gate electrode 155s may be positioned above the sub-barrier layer 136s. The sub-gate electrode 155s may overlap the portion of the sub-barrier layer 136s in the vertical direction (e.g., the thickness direction of the sub-channel layer 132s). The sub-gate electrode 155s may overlap the portion of the sub-drift area DTRs of the sub-channel layer 132s in the vertical direction (e.g., the thickness direction of the sub-channel layer 132s). The sub-gate electrode 155s may be positioned spaced apart from the sub-source electrode 173s in the first direction (the direction X).

In an embodiment, the sub-gate electrode 155s may be positioned on one side of the sub-barrier layer 136s. For example, the sub-gate electrode 155s may be positioned on one side of the sub-barrier layer 136s along the first direction (the direction X). Meanwhile, the sub-source electrode 173s may be positioned on the other side of the sub-barrier layer 136s along the first direction (the direction X).

In an embodiment, the sub-gate electrode 155s may be integrally formed by the same process as the main gate electrode 155m of the main transistor MTR. The sub-gate electrode 155s may be positioned on the same layer as the main gate electrode 155m. The bottom surface of the sub-gate electrode 155s may be positioned at the same level as the bottom surface of the main gate electrode 155m, and the top surface of the sub-gate electrode 155s may be positioned at the same level as the upper surface of the main gate electrode 155m. That is, the bottom surface of the sub-gate electrode 155s and the bottom surface of the main gate electrode 155m may be positioned at the same distance from the upper surface of the substrate 110. The thickness of the sub-gate electrode 155s along the third direction (the direction Z) may be the same as or substantially similar to the thickness of the main gate electrode 155m along the third direction (the direction Z), but embodiments are not limited thereto. At this time, the sub-gate electrode 155s and the main gate electrode 155m may be separated by the separation structure 160, but embodiments are not limited thereto.

The sub-gate electrode 155s may include a conductive material. The sub-gate electrode 155s may include the same material as the main gate electrode 155m. However, embodiments are not limited thereto, the sub-gate electrode 155s may include a different material from the main gate electrode 155m.

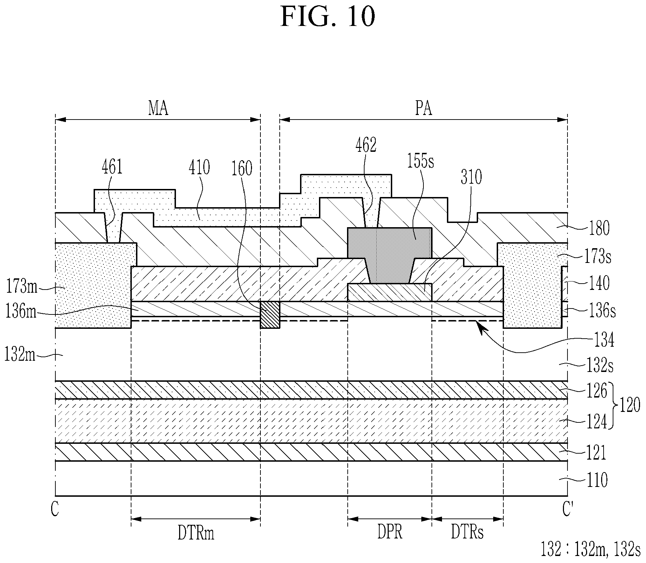

The gate semiconductor pattern 310 may be positioned between the sub-barrier layer 136s and the sub-gate electrode 155s. The gate semiconductor pattern 310 may overlap the sub-gate electrode 155s in the vertical direction (e.g., the thickness direction of the sub-channel layer 132s). At this time, the gate semiconductor pattern 310 may completely overlap the sub-gate electrode 155s in the vertical direction (e.g., the thickness direction of the sub-channel layer 132s), and the upper surface of the gate semiconductor pattern 310 is entirely covered by the sub-gate electrode 155s. In other words, the gate semiconductor pattern 310 may have the same or substantially similar planar shape as the sub-gate electrode 155s. However, embodiments are not limited thereto, the sub-gate electrode 155s may be positioned to cover at least part of the gate semiconductor pattern 310. The explanation of this will be described later with reference to FIG. 10.

A depletion area DPR may be formed within the sub-channel layer 132s by the gate semiconductor pattern 310. The depletion area DPR may be positioned within the sub-drift area DTRs. Here, the depletion area DPR may mean an area where the flow of the 2-dimensional electron gas 134 is interrupted within sub-drift area DTRs. As the depletion area DPR occurs, the channel path may be blocked. The structural shape of the gate semiconductor pattern 310 and the sub-gate electrode 155s may be the same as or substantially similar to the structural shape of the gate semiconductor layer 152 and the main gate electrode 155m, but embodiments are not limited thereto.

The gate semiconductor pattern 310 may include one or more materials selected from Group III-V materials, such as nitrides including Al, Ga, In, B, or combinations thereof. The gate semiconductor pattern 310 may include the same material as the gate semiconductor layer 152, but embodiments are not limited thereto. In an embodiment, the gate semiconductor pattern 310 may be made of a single layer or multiple layers. At least part of the gate semiconductor pattern 310 may include an insulating material. At least one of the layers may include a P-GaN layer. The gate semiconductor pattern may include AIN, GaN, InN, InGaN, AlGaN, AllnN, AllnGaN, or a combination thereof.

In an embodiment, the sub-gate electrode 155s may be a Schottky contact or an ohmic contact with the gate semiconductor pattern 310. For example, if a voltage less than the breakdown voltage of the gate semiconductor pattern 310 is applied to the sub-gate electrode 155s, the sub-gate electrode 155s may become a Schottky contact to the gate semiconductor pattern 310. If a voltage higher than the breakdown voltage of the gate semiconductor pattern 310 is applied to the sub-gate electrode 155s, the Schottky contact between the sub-gate electrode 155s and the gate semiconductor pattern 310 is destroyed and converted into the ohmic contact. At this time, there may be a relatively low resistance value between the gate semiconductor pattern 310 and the sub-gate electrode 155s. Accordingly, as shown in FIG. 8, a current path BC may be formed from the sub-gate electrode 155s to the sub-source electrode 173s through the gate semiconductor pattern 310 and the sub-channel layer 132s. In other words, the sub-gate electrode 155s and the sub-source electrode 173s may be electrically connected. Therefore, the magnitude of the voltage applied to the sub-gate electrode 155s may be adjusted to form the current path BC flowing from the sub-gate electrode 155s to the sub-source electrode 173s, thereby performing the function of the anti-fuse AF according to an embodiment. Here, the breakdown voltage of the gate semiconductor pattern 310 refers to a minimum voltage at which the Schottky contact between the gate semiconductor pattern 310 and the sub-gate electrode 155s is destroyed and converted into an ohmic contact. For example, the breakdown voltage of the gate semiconductor pattern 310 may be about 6V to about 10V, but embodiments are not limited thereto.

The first protection layer 140 may be positioned above the sub-barrier layer 136s. The bottom surface of the first protection layer 140 may be in contact with the sub-barrier layer 136s. In an embodiment, the first protection layer 140 may be integrally formed by the same process as the first protection layer 140 of the main element area MA. In other words, the first protection layer 140 can be positioned above the main-barrier layer 136m of the main element area MA and the sub-barrier layer 136s of the peripheral circuit area PA.

The second protection layer 180 may be positioned above the first protection layer 140 and the sub-source electrode 173s. The second protection layer 180 may cover the gate semiconductor pattern 310 and the sub-gate electrode 155s. The second protection layer 180 may include a trench exposing at least a portion of the sub-source electrode 173s, but embodiments are not limited thereto. The sub-source electrode 173s may be electrically connected to a desired (or predetermined) wiring (e.g., a first voltage line VL1) through the trench of the second protection layer 180.

The sub-source electrode 173s may be positioned on one side of the sub-channel layer 132s. The sub-source electrode 173s may be in contact with the sub-channel layer 132s and may be electrically connected to the sub-channel layer 132s. The sub-source electrode 173s may be positioned outside the sub-drift area DTRs. The interface between the sub-source electrode 173s and the sub-channel layer 132s may be one edge of the sub-drift area DTRs.

In an embodiment, the sub-source electrode 173s may be positioned within a space where at least a portion of the sub-channel layer 132s is recessed. The sub-source electrode 173s may penetrate the sub-barrier layer 136s and be in contact with the side of the sub-channel layer 132s. The sub-source electrode 173s may be electrically connected to sub-drift area DTRs. However, embodiments are not limited to this, and the sub-channel layer 132s need not be recessed, and the sub-source electrode 173s may be positioned on the upper surface of the sub-channel layer 132s.

The sub-source electrode 173s may cover at least part of the upper surface of the first protection layer 140, but embodiments are not limited thereto. Additionally, the sub-source electrode 173s may cover at least a portion of the side of the first protection layer 140. For example, the sub-source electrode 173s may cover the sides of the first protection layer 140. The upper surface of the sub-source electrode 173s may protrude from the upper surface of the first protection layer 140.

The sub-source electrode 173s may include a conductive material. The sub-source electrode 173s may include the same material as the main source electrode 173m and the main drain electrode 175m. The sub-source electrode 173s may be formed by the same process as the main source electrode 173m and the main drain electrode 175m. For example, the sub-source electrode 173s may include metal, a metal alloy, conductive metal nitride, metal silicide, a doped semiconductor material, conductive metal oxide, or conductive metal oxynitride. The sub-source electrode 173s may be made of a single layer or multiple layers. The sub-source electrode 173s may be in ohmic contact with the sub-channel layer 132s. The area within the sub-channel layer 132s that is in contact with the sub-source electrode 173s may be doped with a relatively high concentration compared to other areas, but embodiments are not limited thereto.

The first connection wiring 410 may be positioned above the second protection layer 180. The first connection wiring 410 may be positioned directly above the upper surface of the second protection layer 180, but embodiments are not limited thereto. The first connection wiring 410 may electrically connect one terminal of the main transistor MTR and one terminal of the anti-fuse AF. For example, the first connection wiring 410 may electrically connect the main source electrode 173m and the sub-gate electrode 155s. The first connection wiring 410 may be electrically connected to the main source electrode 173m through the first contact via 461 that penetrates the second protection layer 180, and be electrically connected to the sub-gate electrode 155s through the second contact via 462 that penetrates the second protection layer 180 and the first protection layer 140. The first connection wiring 410 may overlap the portion of the separation structure 160 positioned between the main transistor MTR and the anti-fuse AF in the vertical direction (for example, the thickness direction of the main channel layer 132m). The first connection wiring 410 may overlap the main source electrode 173m and the sub-gate electrode 155s in the vertical direction (e.g., the thickness direction of the main channel layer 132m).

The first connection wiring 410 may include a conductive material. The first connection wiring 410 may include the same or substantially similar material as the sub-source electrode 173s and/or the sub-gate electrode 155s, but embodiments are not limited thereto. For example, the first connection wiring 410 may include metal, a metal alloy, conductive metal nitride, metal silicide, a doped semiconductor material, conductive metal oxide, or conductive metal oxynitride.

In an embodiment, the anti-fuse AF may be separated from the main transistor MTR by the separation structure 160. That is, the separation structure 160 may be positioned between the anti-fuse AF and the main transistor MTR. For example, as shown in FIG. 3, the main transistor MTR and the anti-fuse AF may be positioned spaced apart in the second direction (the direction Y) by the separation structure 160, but embodiments are not limited thereto.

In an embodiment, the separation structure 160 may penetrate the sub-barrier layer 136s. For example, as shown in FIG. 6 and FIG. 7, the separation structure 160 may penetrate the sub-barrier layer 136s and recess at least a portion of the sub-channel layer 132s. However, embodiments are not limited thereto, as another example, the separation structure 160 need not recess the sub-channel layer 132s. As another example, the separation structure 160 may penetrate the sub-barrier layer 136s and the sub-channel layer 132s. As another example, the anti-fuse AF and the main transistor MTR may be separated by the trench penetrating at least part of the sub-channel layer 132s and/or main channel layer 132m.

In an embodiment, the separation structure 160 may be formed by forming a channel layer 132 and a barrier layer on the channel layer 132, and performing an ion implant process onto the barrier layer at an area between the main transistor MTR and the anti-fuse AF. For example, there may be no or little 2-dimensional electron gas formed in the area of the channel layer 132 that overlaps in the third direction (The direction Z) with the area where the ion implant process was performed. At this time, the ion implant area and the channel layer 132 area corresponding thereto may correspond to the separation structure 160. Accordingly, the channel layer 132 may be divided into the main channel layer 132m and the sub-channel layer 132s, and the barrier layer may be divided into the main barrier layer 136m and the sub-barrier layer 136s. As another example, the separation structure 160 may be formed by performing an ion implant process on the channel layer 132. The ion implanted area in the channel layer 132 may correspond to the separation structure 160. There may be no or little 2-dimensional electron gas formed in the area of the channel layer 132 where the ion implant process was performed. The material used in the ion implant process may be argon (Ar) ion.

However, embodiments are not limited thereto, the separation structure 160 may be formed by forming a channel layer 132 and a barrier layer on the channel layer 132, forming a trench penetrating the barrier layer, and then filling the trench with an insulating material. The insulating material constituting the separation structure 160 may include the same material as the first protection layer 140. For example, the insulating material constituting the separation structure 160 may include oxide such as SiOz or Al₂O₃. As another example, the insulating material constituting the separation structure 160 may include nitride such as SiN or oxynitride such as SiON. However, embodiments are not limited thereto, the insulating material constituting the separation structure 160 may include a material different from the first protection layer 140. At this time, at least part of the main channel layer 132m and/or the sub-channel layer 132s may be recessed together.

The anti-fuse AF of the semiconductor device according to this embodiment may include a sub-gate electrode 155s and a sub-source electrode 173s, and need not include a sub-drain electrode 175s. That is, the sub-source electrode 173s may be positioned on one side of the sub-barrier layer 136s, and the sub-gate electrode 155s may be positioned on the other side. However, embodiments are not limited to this, and the anti-fuse AF may further include a sub-drain electrode 175s. An explanation of this will be described later with reference to FIG. 11 to FIG. 13.

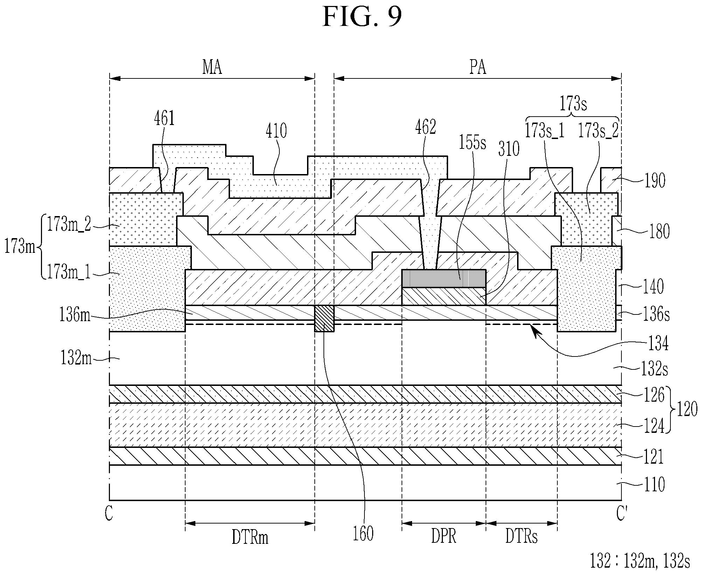

Hereinafter, anti-fuses of semiconductor devices according to some embodiments is described with reference to FIG. 9 and FIG. 10.

FIG. 9 and FIG. 10 are cross-sectional views of semiconductor devices according to some embodiments taken along a line C-C' of FIG. 3.

FIG. 9 and FIG. 10 show some variations of the semiconductor device according to the embodiment shown in FIG. 1 to FIG. 8. The embodiments shown in FIG. 9 and FIG. 10 are the same as many parts as the embodiment shown in FIG. 1 to FIG. 8, so that the description thereof is omitted and the differences will be mainly explained. Additionally, the same reference numeral is used for the same component as the previous embodiment.

Referring to FIG. 9, a semiconductor device according to an embodiment may have a plurality of main source electrodes 173m and sub-source electrodes 173s.

The main source electrode 173m of the semiconductor device according to the present embodiment may include a plurality of main source electrodes (173m_1 and 173m_2) sequentially stacked on the main channel layer 132m. The first main source electrode 173m_1 may be positioned above the main channel layer 132m. The first main source electrode 173m_1 may be directly in contact with the main channel layer 132m and be electrically connected to the main channel layer 132m. The second main source electrode 173m_2 may be positioned above the first main source electrode 173m_1. The second main source electrode 173m_2 may be electrically connected to the first main source electrode 173m_1. The second main source electrode 173m_2 may be electrically connected to the sub-gate electrode 155s through the first connection wiring 410.

The plurality of main source electrodes 173m_1 and 173m_2 may include a conductive material. The plurality of main source electrodes 173m_1 and 173m_2 may include the same material, but embodiments are not limited thereto, and the plurality of main source electrodes 173m_1 and 173m_2 may each include different materials. For example, the plurality of main source electrodes 173m_1 and 173m_2 may include metal, metal alloy, conductive metal nitride, metal silicide, a doped semiconductor material, conductive metal oxide, or conductive metal oxynitride.

Additionally, the sub-source electrode 173s of the semiconductor device according to the present embodiments may include a plurality of sub-source electrodes 173s_1 and 173s_2 sequentially stacked on the main channel layer 132m. The first sub-source electrode 173s_1 may be positioned above the sub-channel layer 132s. The first sub-source electrode 173s_1 may be in directly contact with the sub-channel layer 132s and be electrically connected to the sub-channel layer 132s. The second sub-source electrode 173s_2 may be positioned above the first sub-source electrode 173s_1. The second sub-source electrode 173s_2 may be electrically connected to the first sub-source electrode 173s_1.

The semiconductor device according to the present embodiment may further include a third protection layer 190 positioned above the second protection layer 180. At this time, the plurality of main source electrodes 173m_1 and 173m_2 may be covered by a plurality of protection layers. For example, the first protection layer 140 may cover at least part of the side of the first main source electrode 173m_1. The second protection layer 180 may cover at least part of the upper surface of the first main source electrode 173m_1 and at least part of the side surface of the second main source electrode 173m_2. The third protection layer 190 may cover the top surface of the second main source electrode 173m_2. Additionally, the first connection wiring 410 may be positioned above the third protection layer 190. The first connection wiring 410 may be electrically connected to the main source electrode 173m through the first contact via 461 that penetrates the third protection layer 190, and be electrically connected to the sub-gate electrode 155s through the second contact via 462 that penetrates the third protection layer 190, the second protection layer 180, and the first protection layer 140. At this time, as shown in FIG. 9, the second contact via 462 may have a bend part between the third protection layer 190 and the second protection layer 180, but embodiments are not limited thereto.

FIG. 9 shows that each of the main source electrode 173m and the sub-source electrode 173s are provided in plurality, but embodiments are not limited thereto, the main drain electrode may be provided in plurality. At this time, the number, shape, and arrangement of the plurality of main drain electrodes may be the same as or substantially similar to the number, shape, and arrangement of the plurality of main source electrodes 173m_1 and 173m_2.

Referring to FIG. 10, a sub-gate electrode 155s of a semiconductor device according to an embodiment may penetrate the first protection layer 140 and be connected to the gate semiconductor pattern 310.

In the present embodiment, the sub-gate electrode 155s may penetrate the first protection layer 140. For example, the sub-gate electrode 155s may penetrate the first protection layer 140 on the gate semiconductor pattern 310. Accordingly, at least a portion of the side of the sub-gate electrode 155s may be in contact with the first protection layer 140. The sub-gate electrode 155s may overlap the gate semiconductor pattern 310 in the vertical direction (e.g., the thickness direction of the channel layer 132). The bottom surface of the sub-gate electrode 155s may be in contact with the upper surface of the gate semiconductor pattern 310. At this time, the sub-gate electrode 155s may be positioned on at least part of the gate semiconductor pattern 310. The upper surface of the gate semiconductor pattern 310 may be in contact with the sub-gate electrode 155s and the first protection layer 140. However, embodiments are not limited thereto, the gate semiconductor pattern 310 may completely overlap the sub-gate electrode 155s.

The placement and shape of the sub-gate electrode 155s according to some embodiments may vary due to the process characteristic of forming the gate semiconductor pattern 310 on the sub-barrier layer 136s, forming the first protection layer 140, and then forming the sub-gate electrode 155s that penetrates the first protection layer 140 and is connected to the gate semiconductor pattern 310.

In the present embodiment, the first connection wiring 410 may electrically connect the sub-gate electrode 155s and the main source electrode 173m through a fist contact via 461 and a second contact via 462 that penetrate the second protection layer 180.

Hereinafter, an anti-fuse of a semiconductor device according to an embodiment is described with reference to FIG. 11 to FIG. 13.

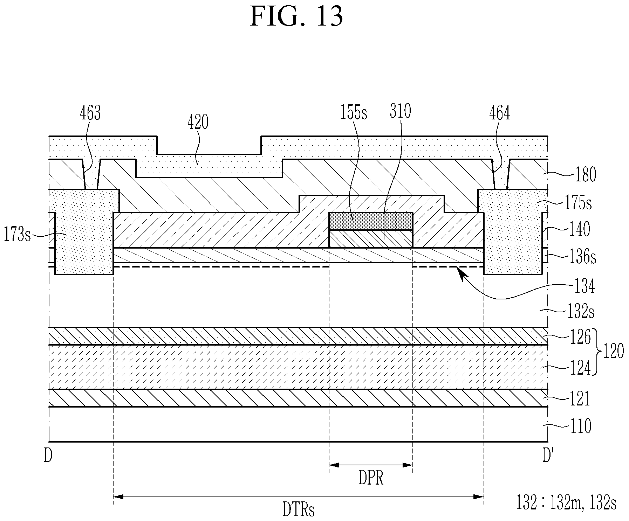

FIG. 11 is a circuit diagram showing a semiconductor device according to an embodiment. FIG. 12 is a top plan view showing the semiconductor device of FIG. 11. FIG. 13 is a cross-sectional view taken along a line D-D' in FIG. 12.

FIG. 11 to FIG. 13 show a variation of the semiconductor device shown in FIG. 1 to FIG. 8. The embodiment shown in FIG. 11 to FIG. 13 include many parts that are the same as the embodiment shown in FIG. 1 to FIG. 8, the description thereof will be omitted and the differences will be mainly explained. Additionally, the same reference numeral is used for the same component as the previous embodiment.

First, referring to FIG. 11, an anti-fuse AF of a semiconductor device according to the present embodiment may further include a first electrode Da electrically connected to a second electrode Sa. That is, the anti-fuse AF may include a gate electrode Ga, a first electrode Da, and a second electrode Sa.

The first electrode Da of the anti-fuse AF may be electrically connected to the second electrode Sa. The first electrode Da of the anti-fuse AF may be electrically connected to the first voltage line VL1, which supplies the first power voltage. Here, the first electrode Da of the anti-fuse AF refer to the sub-drain electrode (e.g., 175s in FIG. 12) of the anti-fuse AF.

The anti-fuse AF can be programmed to have a small resistance value between the gate electrode Ga and the second electrode Sa depending on the signal applied to the gate electrode Ga. At this time, because the first electrode Da and the second electrode Sa of the anti-fuse AF are electrically connected, the resistance value between the gate electrode Ga and the first electrode Da may be small.

Next, further referring to FIG. 12 and FIG. 13, the anti-fuse AF of the semiconductor device according to the present embodiment may further include a sub-drain electrode 175s. Here, the sub-drain electrode 175s may correspond to the first electrode (Da in FIG. 11) of the anti-fuse AF.

In the present embodiment, the sub-drain electrode 175s may be positioned on one side of the sub-gate electrode 155s. In other words, the sub-drain electrode 175s may be positioned on one side of the sub-gate electrode 155s along the first direction (the direction X), and the sub-source electrode 173s may be positioned on the other side of the sub-gate electrode 155s along the first direction (the direction X). In other words, in a plane, the sub-gate electrode 155s may be positioned between the sub-source electrode 173s and the sub-drain electrode 175s.

The sub-drain electrode 175s may be extended in the same direction as the main drain electrode 175m. For example, the main drain electrode 175m may extend in the second direction (the direction Y), and the sub-drain electrode 175s may extend in the second direction (the direction Y) on one side of the main drain electrode 175m. At this time, the sub-drain electrode 175s and the main drain electrode 175m may be separated by the separation structure 160.

In the present embodiment, the sub-drift area DTRs may be positioned between the sub-drain electrode 175s and the sub-source electrode 173s. In other words, the sub-drift area DTRs may mean the area from one side of the sub-channel layer 132s in contact with the sub-source electrode 173s to the other side of the sub-channel layer 132s in contact with the sub-drain electrode 175s.

In the present embodiment, the sub-drain electrode 175s may have the same or substantially similar cross-section shape as the sub-source electrode 173s. For example, on the cross-section consisting of the first direction (the direction X) and the second direction (the direction Y), the sub-drain electrode 175s may have the same or substantially similar shape as the sub-source electrode 173s. The sub-drain electrode 175s may be positioned within a space where at least a portion of the sub-channel layer 132s is recessed. The sub-drain electrode 175s may penetrate the sub-barrier layer 136s and be in contact with the side of the sub-channel layer 132s. The sub-drain electrode 175s may be electrically connected to the sub-drift area DTRs. However, embodiments are not limited to this, and the sub-channel layer 132s need not be recessed, and the sub-drain electrode 175s may be positioned on the upper surface of the sub-channel layer 132s.

The sub-drain electrode 175s may include a conductive material. The sub-drain electrode 175s may include the same material as the sub-source electrode 173s. The sub-drain electrode 175s may be formed by the same process as the sub-source electrode 173s.

The anti-fuse AF of the semiconductor device according to the present embodiment may further include a second connection wiring 420 connecting the sub-source electrode 173s and the sub-drain electrode 175s.

The second connection wiring 420 may be positioned above the second protection layer 180. The second connection wiring 420 may be positioned directly above the upper surface of the second protection layer 180, but embodiments are not limited thereto. The second connection wiring 420 may be positioned on the same layer as the first connection wiring 410, but embodiments are not limited thereto. For example, the second connection wiring 420 may be positioned above or below the first connection wiring 410. As an example, the first connection wiring 410 may be positioned above the first protection layer 140, and the second connection wiring 420 may be positioned above the second protection layer 180. As another example, the first connection wiring 410 may be positioned on the second protection layer 180, and the second connection wiring 420 may be positioned on a capping layer covering the second protection layer 180. In FIG. 12, the second connection wiring 420 is shown as extending in the first direction (the direction X), but embodiments are not limited thereto.

The second connection wiring 420 electrically connect between the sub-source electrode 173s and the sub-drain electrode 175s. For example, the second connection wiring 420 may be electrically connected to the sub-source electrode 173s through the third contact via 463 penetrating the second protection layer 180, and be electrically connected to the sub-drain electrode 175s through the fourth contact via 464 penetrating the second protection layer 180. The second connection wiring 420 may overlap the sub-source electrode 173s and the sub-drain electrode 175s in the vertical direction (e.g., the thickness direction of the main channel layer 132m).

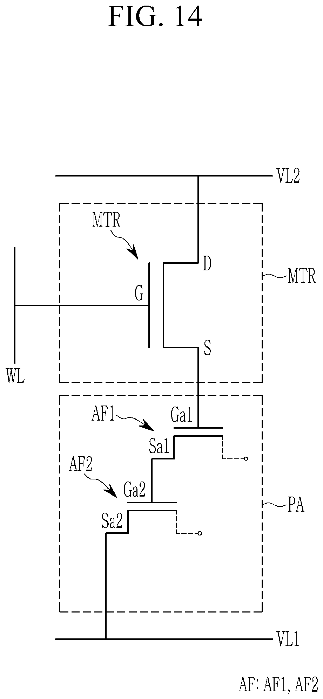

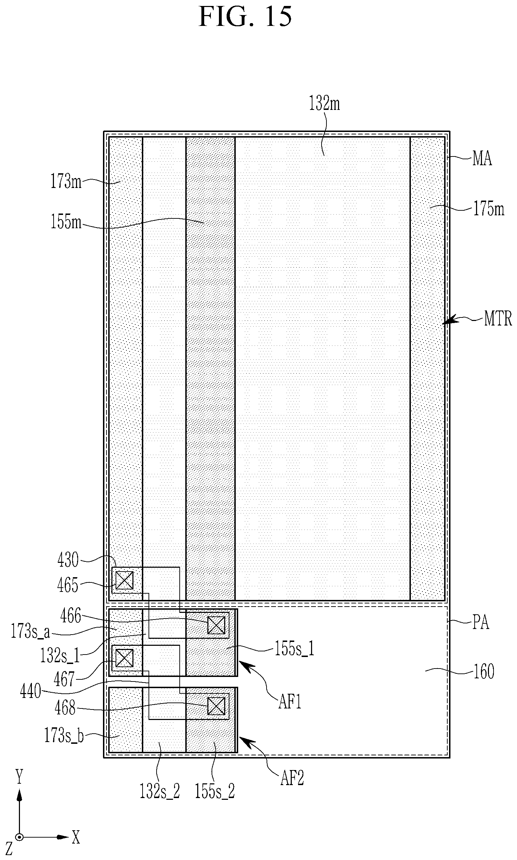

Hereinafter, an anti-fuse of a semiconductor device according to an embodiment will be described with further reference to. FIG. 14 and FIG. 15.

FIG. 14 is a circuit diagram showing a semiconductor device according to an embodiment. FIG. 15 is a top plan view showing the semiconductor device of FIG. 14.

FIG. 14 and FIG. 15 show a variation of the semiconductor device shown in FIG. 1 to FIG. 8. The embodiment shown in FIG. 14 and FIG. 15 has many parts that are the same as the embodiment shown in FIG. 1 to FIG. 8, so that the description thereof will be omitted and the differences will be mainly explained. Additionally, the same reference numeral is used for the same component as the previous embodiment.

First, referring to FIG. 14, a semiconductor device according to the present embodiment may have a plurality of anti-fuses AFs. For example, the anti-fuse AF may include a first anti-fuse AF1 that is electrically connected to one terminal of the main transistor MTR, and a second anti-fuse AF2 that connects the first anti-fuse AF1 and the first voltage line VL1.

The first anti-fuse AF1 may include a first gate electrode Ga1 and a first sub-electrode Sa1. The first gate electrode Ga1 of the first anti-fuse AF1 may be electrically connected to the second electrode S of the main transistor MTR. The first sub-electrode Sa1 of the first anti-fuse AF1 may be electrically connected to the second gate electrode Ga2 of the second anti-fuse AF2.

The second anti-fuse AF2 may include a second gate electrode Ga2 and a second sub-electrode Sa2. The second gate electrode Ga2 of the second anti-fuse AF2 may be electrically connected to the first sub-electrode Sa1 of the first anti-fuse AF1. The second sub-electrode Sa2 of the second anti-fuse AF2 may be electrically connected to the first voltage line VL1.

In the present embodiment, a first gate voltage or a second gate voltage may be applied to the word line WL to operate the anti-fuse AF.

As described above, in the second mode, the word line WL may apply the second gate voltage to the gate electrode G of the main transistor MTR. At this time, the second gate voltage may be greater than or equal to the breakdown voltage of the gate semiconductor pattern of the plurality of anti-fuses AF1 and AF2. For example, the second gate voltage may be greater than the breakdown voltage of the first gate semiconductor pattern of the first anti-fuse AF1, and may be greater than the breakdown voltage of the second gate semiconductor pattern of the second anti-fuse AF2.

Accordingly, the Schottky contact between the gate semiconductor pattern of the plurality of anti-fuses AF1 and AF2 and the sub-gate electrode may be destroyed and converted into an ohmic contact. A low resistance value may be formed between the gate semiconductor pattern of the plurality of anti-fuses AF1 and AF2 and the sub-gate electrode. Therefore, the second electrode S of the main transistor MTR may be electrically connected to the first voltage line VL1, where the first power voltage is supplied through the first anti-fuse AF1 and the second anti-fuse AF2.

Further referring to FIG. 15, the first anti-fuse AF1 of the semiconductor device according to the present embodiment may include a first sub-channel layer 132s_1, a first sub-barrier layer placed on the first sub-channel layer 132s_1, a first sub-source pattern 173s_a placed on the first sub-channel layer 132s_1, a first sub-gate electrode 155s_1 placed on the first sub-barrier layer, a first gate semiconductor pattern positioned between the first sub-gate electrode 155s_1 and the first sub-barrier layer, and a third connection wiring 430. Also, the second anti-fuse AF2 of the semiconductor device according to the present embodiment may include a second sub-channel layer 132s_2, a second sub-barrier layer placed on the second sub-channel layer 132s_2, a second sub-source pattern 173s_b placed on the second sub-channel layer 132s_2, a second sub-gate electrode 155s_2 placed on the second sub-barrier layer, a second gate semiconductor pattern positioned between the second sub-gate electrode 155s_2 and the second sub-barrier layer, and a fourth connection wiring 440.

A separation structure 160 may be positioned between the first sub-barrier layer and the second sub-barrier layer. The first sub-barrier layer and the second sub-barrier layer may be defined by separation structure 160. For example, as shown in FIG. 15, the first sub-barrier layer and the second sub-barrier layer may be positioned spaced apart along the second direction (the direction Y), but embodiments are not limited thereto. The remaining descriptions of the first sub-barrier layer and the second sub-barrier layer is the same as or substantially similar to the description of the sub-barrier layer (136s in FIG. 6) of the embodiment of FIG. 1 to FIG. 8, so that it will be omitted.

In the present embodiment, the third connection wiring 430 may electrically connect the main source electrode 175m and the first sub-gate electrode 155s_1 of the first anti-fuse AF1. For example, the third connection wiring 430 may be electrically connected to the main source electrode 173m through the fifth contact via 465, and may be electrically connected to the first sub-gate electrode 155s_1 through the sixth contact via 466. At this time, the third connection wiring 430 may be positioned above the second protection layer, but embodiments are not limited thereto.

Additionally, the fourth connection wiring 440 may electrically connect the first sub-source pattern 173s_a of the first anti-fuse AF1 and the second sub-gate electrode 155s_2 of the second anti-fuse AF2. For example, the fourth connection wiring 440 may be electrically connected to the first sub-source pattern 173s_a through the seventh contact via 467, and be electrically connected to the second sub-gate electrode 155s_2 through the eighth contact via 468. At this time, the fourth connection wiring 440 may be positioned above the second protection layer, but embodiments are not limited thereto.

In the present embodiment, a Schottky contact or an ohmic junction may be formed between the first gate semiconductor pattern and the first sub-gate electrode 155s_1, and between the second gate semiconductor pattern and the second sub-gate electrode 155s_2. For example, if a voltage less than the breakdown voltage of the gate semiconductor patterns is applied to the first sub-gate electrode 155s_1, a Schottky contact may be formed between the first gate semiconductor pattern and the first sub-gate electrode 155s_1 and between the second gate semiconductor pattern and the second sub- gate electrode 155s_2. If a voltage higher than the breakdown voltage of the gate semiconductor patterns is applied to the first sub-gate electrode 155s_1, a Schottky contact may be destroyed and converted into an ohmic contact between the first gate semiconductor pattern and the first sub-gate electrode 155s_1, and between the second gate semiconductor pattern and the second sub-gate electrode 155s_2. At this time, the area between the first gate semiconductor pattern and first sub-gate electrode 155s_1 and between the second gate semiconductor pattern and second sub-gate electrode 155s_2 may have a relatively low resistance value. Accordingly, a current path may be formed from the first sub-gate electrode 155s_1 to the second sub-source pattern 173s_b through the first sub-source pattern 173s_a and the second sub-gate electrode 155s_2.

In the present embodiment, the plurality of anti-fuses AF1 and AF2 are described as being coupled in series, but embodiments are not limited thereto, the plurality of anti-fuses AF1 and AF2 may be coupled in parallel. For example, one terminal of the plurality of anti-fuses AF1 and AF2 may be electrically connected to one terminal of the main transistor MTR (for example, the second electrode S), and the other terminal of the plurality of anti-fuses AF1 and AF2 may be electrically connected to the first voltage line VL1. As another example, the plurality of anti-fuses AF1 and AF2 may be connected in a combination of in series and in parallel. In addition, the case where the number of plurality of anti-fuses AF1 and AF2 is 2 has been explained, but embodiments are not limited thereto. For example, the number of plurality of anti-fuses may 3 or more.

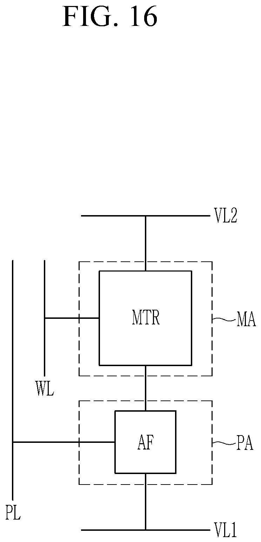

Hereinafter, an anti-fuse of a semiconductor devices according to an embodiment will be described with reference to FIG. 16 to FIG. 19.

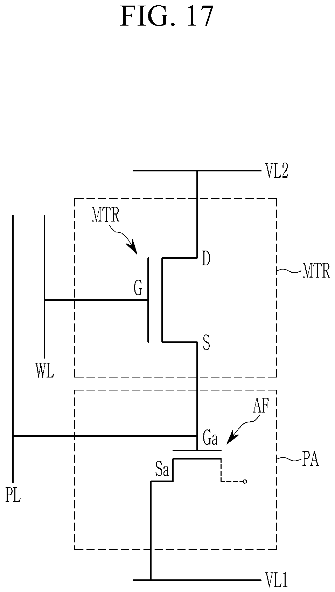

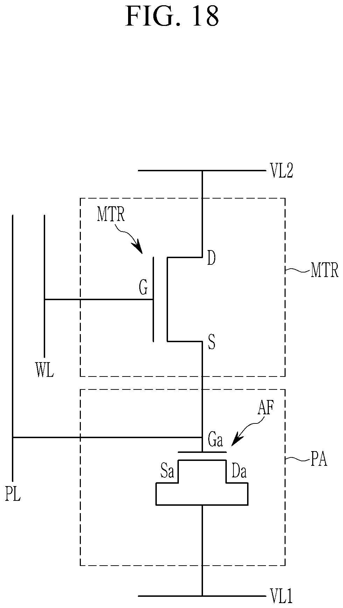

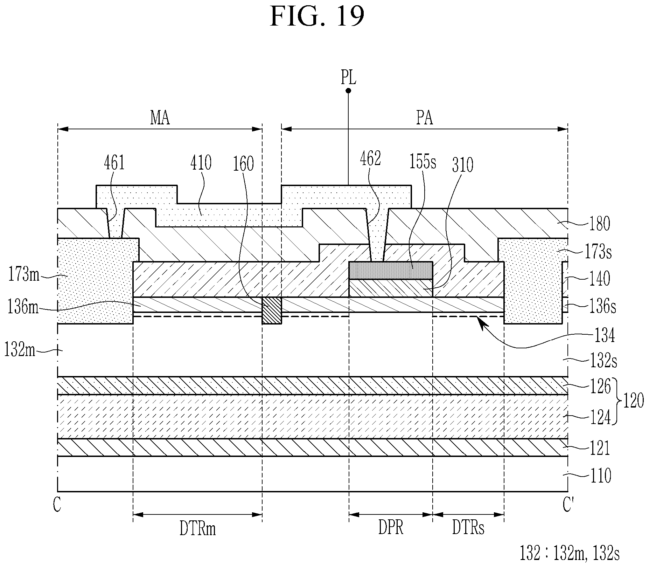

FIG. 16 is a block diagram showing a semiconductor device according to an embodiment. FIG. 17 and FIG. 18 are circuit diagrams showing semiconductor devices according to some embodiments. FIG. 19 is a cross-sectional view showing the semiconductor device of FIG. 18, taken along a line C-C' in FIG. 3.

FIG. 16 to FIG. 19 show some variations of the semiconductor device of FIG. 1 to FIG. 8. The embodiments shown in FIG. 16 to FIG. 19 have many parts that are the same as the embodiment shown in FIG. 1 to FIG. 8, so that description thereof will be omitted and the differences will be mainly explained. Additionally, the same reference numeral is used for the same component as the previous embodiment. The embodiments shown in FIG. 16 to FIG. 19 may further include a separate wiring for applying a program voltage to the anti-fuse AF.

First, referring to FIG. 16, a semiconductor device according to an embodiment may include a main transistor MTR, an anti-fuse AF connected to one terminal of the main transistor MTR, a second voltage line VL2, which is connected to the other terminal of the main transistor MTR and supplies a second power voltage, a word line WL, which is connected to the main transistor MTR and applies a gate voltage, a first voltage line VL1 that is connected to the anti-fuse AF and applies the first power voltage, and a program voltage line PL connected to the anti-fuse AF and applying a program voltage.

In the present embodiment, the anti-fuse AF may be programmed by the program voltage applied at the program voltage line PL. The anti-fuse AF may be programmed by program voltage so that the main transistor MTR may be electrically connected to the first voltage line VL1. For example, according to the signal applied to the anti-fuse AF, the Schottky contact between the gate semiconductor pattern (310 in FIG. 19) and the sub-gate electrode (155s in FIG. 19) may be destroyed and converted into an ohmic contact. At this time, the anti-fuse AF may be converted to a state with relatively low resistance.

In some embodiments, the main transistor MTR and the anti-fuse AF may have various connection relationships.

For example, further referring to FIG. 17, the anti-fuse AF of the semiconductor device according to an embodiment may include a gate electrode Ga and a second electrode Sa. The gate electrode Ga of the anti-fuse AF may be electrically connected to the second electrode S of the main transistor MTR. The second electrode Sa of the anti-fuse AF may be electrically connected to the first voltage line VL1, which supplies the first power voltage.

In some embodiments, the gate electrode Ga of the anti-fuse AF may be electrically connected to the program voltage line PL to apply the program voltage. The anti-fuse AF may be programmed to have a low resistance value between the gate electrode Ga and the second electrode Sa depending on the program voltage. Here, the program voltage may be greater than or equal to the breakdown voltage of the gate semiconductor pattern (310 in FIG. 19) of the anti-fuse AF. Accordingly, the Schottky contact between the gate semiconductor pattern (310 in FIG. 19) of the anti-fuse AF and the gate electrode Ga may be destroyed and converted into an ohmic contact. At this time, the anti-fuse AF may have a relatively low resistance between the gate semiconductor pattern (310 in FIG. 19) and the gate electrode Ga. For example, the breakdown voltage of the gate semiconductor pattern (310 in FIG. 3) may be about 6V to about 10V, but embodiments are not limited thereto. Accordingly, a current path may be formed from the gate electrode Ga of the anti-fuse AF to the second electrode Sa of the anti-fuse AF, and accordingly, the second electrode S of the main transistor MTR may be electrically connected to the first voltage line VL1.

As another example, referring to FIG. 18, an anti-fuse AF of the semiconductor device according to an embodiment may further include a first electrode Da. That is, the anti-fuse AF may include a gate electrode Ga, a first electrode Da, and a second electrode Sa.

The first electrode Da of the anti-fuse AF may be electrically connected to the second electrode Sa. The first electrode Da of the anti-fuse AF may be electrically connected to the first voltage line VL1, which supplies the first power voltage. Here, the gate electrode Ga of the anti-fuse AF may refer to the sub-gate electrode155s in FIG. 19, and the first electrode Da of the anti-fuse AF may refer to the sub-drain electrode 175s in FIG. 12. The description of the sub-drain electrode is the same as or substantially similar to the description of the sub-drain electrode of the embodiment of FIG. 11 to FIG. 13, and thus it will be omitted.

Referring further to FIG. 19, the program voltage line PL may be electrically connected to the first connection wiring 410. Accordingly, the program voltage may be applied to the sub-gate electrode 155s through the program voltage line PL. However, embodiments are not limited thereto, for example, the program voltage line PL may be electrically connected to the main source electrode 173m or the sub-gate electrode 155s through a separate contact via.

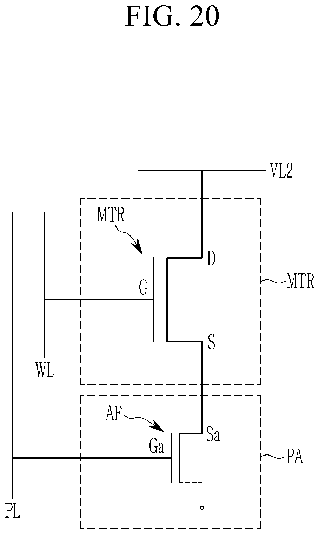

Hereinafter, the anti-fuse of the semiconductor devices according to several embodiments will be described further with reference to FIG. 20 to FIG. 24.

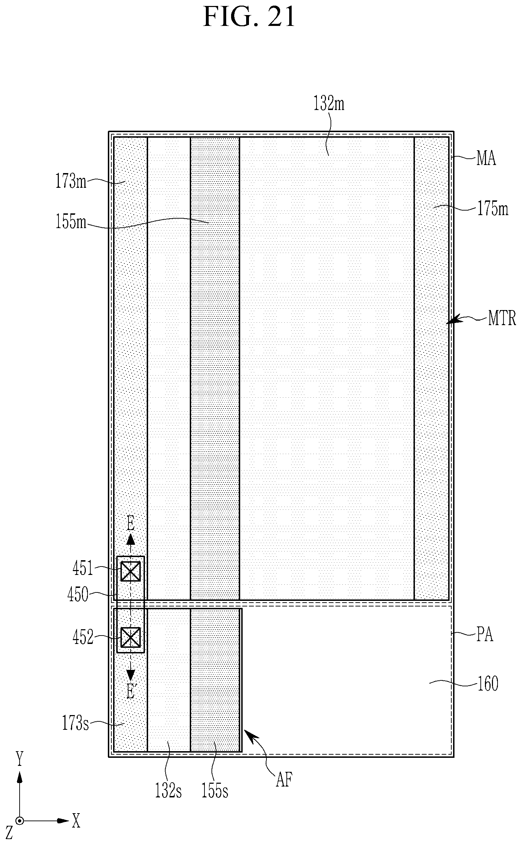

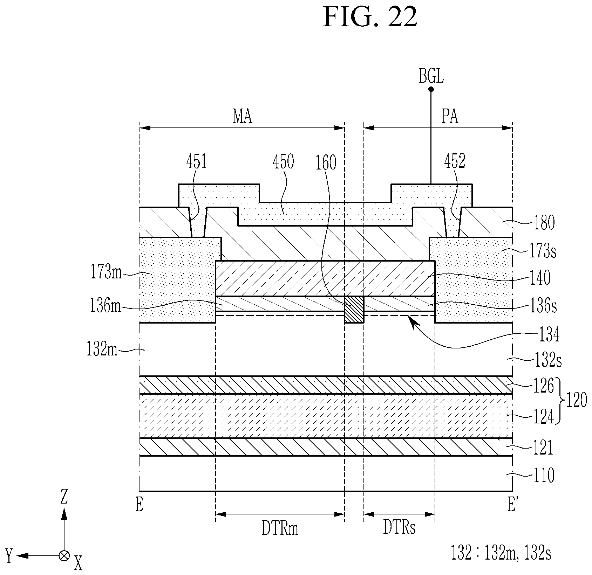

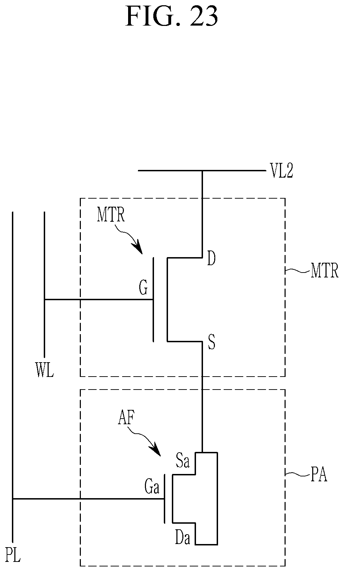

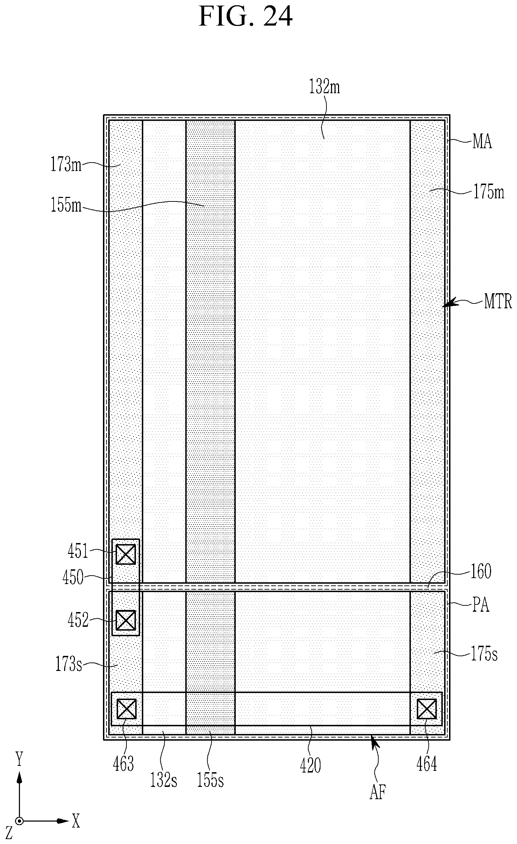

FIG. 20 is a circuit diagram showing a semiconductor device according to some embodiments. FIG. 21 is a top plan view showing the semiconductor device of FIG. 20. FIG. 22 is a cross-sectional view taken along a line E-E' of FIG. 21. FIG. 23 is a circuit diagram showing a semiconductor device according to an embodiment. FIG. 24 is a top plan view showing the semiconductor device of FIG. 23.

FIG. 20 to FIG. 24 are some variations of the semiconductor devices shown in FIG. 16 to FIG. 19. The embodiments shown at FIG. 20 to FIG. 24 has many parts that are the same as the embodiments shown in FIG. 16 to FIG. 19 so that description thereof will be omitted and the differences will be mainly explained. Additionally, the same reference numeral is used for the same component as the previous embodiments.

First, referring to FIG. 20, a semiconductor device according to an embodiment need not include the first voltage line VL1 that is electrically connected to one terminal of the anti-fuse AF and supplies the first power voltage.

In the present embodiment, the second electrode Sa of the anti-fuse AF may be electrically connected to the second electrode S of the main transistor MTR. The gate electrode Ga of the anti-fuse AF may be electrically connected to the program voltage line PL that applies the program voltage. The anti-fuse AF may be programmed to have a low resistance value between the gate electrode Ga and the second electrode Sa depending on the program voltage. Accordingly, a current path may be formed from the gate electrode Ga of the anti-fuse AF to the second electrode Sa of the anti-fuse AF, and accordingly, the second electrode S of the main transistor MTR may be electrically connected to the program voltage line PL.

Referring further to FIG. 21 and FIG. 22, the anti-fuse AF of the semiconductor device according to an embodiment may further include a fifth connection wiring 450 that electrically connects the sub-source electrode 173s and the main source electrode 173m.

The fifth connection wiring 450 may be positioned above the second protection layer 180. The fifth connection wiring 450 may be positioned directly above the upper surface of the second protection layer 180, but embodiments are not limited thereto. The fifth connection wiring 450 may electrically connect one terminal of the main transistor MTR and one terminal of the anti-fuse AF. For example, the fifth connection wiring 450 electrically connect the main source electrode 173m and the sub-source electrode 173s. The fifth connection wiring 450 may be electrically connected to the main source electrode 173m through the ninth contact via 451 that penetrates the second protection layer 180, and be electrically connected to the sub-source electrode 173s through the tenth contact via 452 that penetrates the second protection layer 180. The fifth connection wiring 450 may overlap the portion of the separation structure 160 positioned between the main transistor MTR and the anti-fuse AF in the vertical direction (e.g., the thickness direction of the main channel layer 132m). The fifth connection wiring 450 may overlap the main source electrode 173m and the sub-source electrode 173s in the vertical direction (e.g., the thickness direction of the main channel layer 132m). In the present embodiment, the fifth connection wiring 450 extends in the second direction (the direction Y), but embodiments are not limited thereto.

The fifth connection wiring 450 may include a conductive material. The fifth connection wiring 450 may include the same material as or substantially similar to the sub-source electrode 173s and/or the sub-gate electrode 155s, but embodiments are not limited thereto. For example, the fifth connection wiring 450 may include metal, a metal alloy, conductive metal nitride, metal silicide, a doped semiconductor material, conductive metal oxide, or conductive metal oxynitride.

Referring to FIG. 23, an anti-fuse AF of a semiconductor device according to an embodiment may further include a first electrode Da. That is, the anti-fuse AF may include a gate electrode Ga, a first electrode Da, and a second electrode Sa. The first electrode Da of the anti-fuse AF may be electrically connected to the second electrode Sa. Here, the first electrode Da of the anti-fuse AF may refer to the sub-drain electrode (175s in FIG. 24) of the anti-fuse AF.

Referring further to FIG. 24, the anti-fuse AF of the semiconductor device according to an embodiment may further include a sub-drain electrode 175s and a fifth connection wiring 450 connecting the sub-source electrode 173s and the sub-drain electrode 175s. At this time, the sub-drain electrode 175s may correspond to the first electrode (Da in FIG. 23) of the anti-fuse AF.

In the present embodiment, the sub-drain electrode 175s may be positioned on one side of the sub-gate electrode 155s. In other words, the sub-drain electrode 175s may be positioned on one side of the sub-gate electrode 155s along the first direction (the direction X), and the sub-source electrode 173s may be positioned on the other side of the sub-gate electrode 155s along the first direction (the direction X). In other words, in a plane, the sub-gate electrode 155s may be positioned between the sub-source electrode 173s and the sub-drain electrode 175s. The description of the sub-drain electrode 175s of FIG. 24 is the same as or substantially similar to the description of the sub-drain electrode 175s of FIG. 12, and thus it will be omitted.

hereinafter, semiconductor devices according to some embodiments will be described with reference to FIG. 25 to FIG. 27.

FIG. 25 to FIG. 27 are circuit diagrams showing a plurality of units of semiconductor devices according to some embodiments. FIG. 25 to FIG. 27 show some variations of the semiconductor device shown in FIG. 1 to FIG. 8.

The embodiment of FIG. 1 to FIG. 24 shows that the main transistor MTR include one first electrode D, one second electrode S, and one gate electrode G.

Referring to FIG. 25 to FIG. 27, the main transistor MTR of the semiconductor device according to some embodiments may include a plurality of units MTR_U.

Each of the plurality of units MTR_U may include one second electrode S_U, one first electrode D_U, and one gate electrode G_U. At this time, the second electrodes S_U of the plurality of units MTR_U may be electrically connected to each other, the gate electrodes G_U of the plurality of units MTR_U may be electrically connected to each other, and the first electrodes D_U of the plurality of units MTR_U may be electrically connected to each other. Accordingly, the plurality of units MTR_U may function as one transistor, but embodiments are not limited thereto.

In the present embodiments, the plurality of units MTR_U may be arranged in one direction (e.g., the first direction (the direction X)). At this time, a pair of the plurality of units MTR_U that are adjacent to each other in one direction may be symmetrical to each other with reference to the other direction that intersects one direction (for example, the second direction (the direction Y)), but embodiments are not limited thereto..

Referring to FIG. 25, the first electrodes D_U of the plurality of units MTR_U may be electrically connected to the second voltage line VL2, which supplies the second power voltage, and the gate electrodes G_U of the plurality of units MTR_U may be electrically connected to the word line WL that applies the gate signal (e.g., a first gate voltage or a second gate voltage).

Additionally, the anti-fuse AF may be electrically connected to at least one of the plurality of units MTR_U. As an example, the gate electrode Ga of the anti-fuse AF may be electrically connected to at least one second electrode S_U among the plurality of units MTR_U, but embodiments are not limited thereto. Here, the anti-fuse AF may be configured as a part of any one of the plurality of units MTR_U separated by the separation structure (160 in FIG. 3) and positioned in the peripheral circuit area PA, but embodiments are not limited thereto.

Accordingly, the anti-fuse AF may control the plurality of units MTR_U to operate as a redundancy element. The driving method of the anti-fuse AF according to these embodiments is the same as or substantially similar to the driving method of the anti-fuse AF described in FIG. 1 to FIG. 8, so that detailed description thereof is omitted.

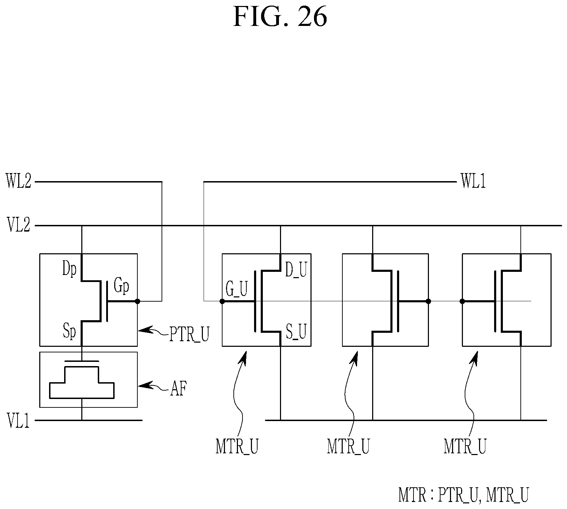

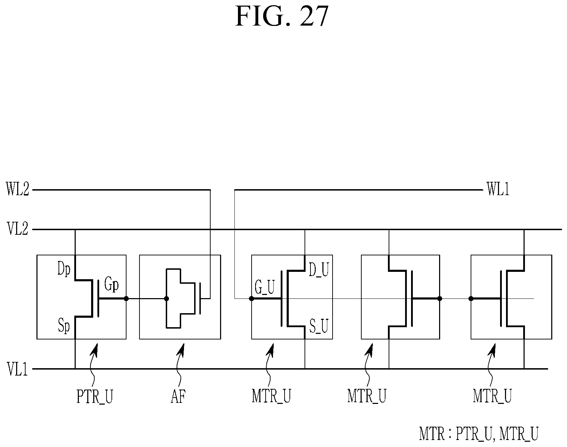

Referring to FIG. 26 and FIG. 27, the main transistor MTR of a semiconductor device according to some embodiments may include a plurality of units MTR_U functioning as a transistor element and a spare unit PTR_U functioning as a redundancy element. The spare unit PTR_U may be at least one unit among the plurality of units MTR_U, but embodiments are not limited thereto.

In some embodiments, the gate electrode G_U of the plurality of units MTR_U may be electrically connected to a first word line WL1 applying the first gate voltage. Additionally, the first electrodes D_U of the plurality of units MTR_U can be electrically connected to the second voltage line VL2, and the second electrodes S_U of the plurality of units MTR_U may be electrically connected to each other.

Meanwhile, the gate electrode Gp of the spare unit PTR_U may be electrically connected to the second word line WL2 that applies the second gate voltage. For example, as shown in FIG. 26, the gate electrode Gp of the spare unit PTR_U may be directly connected to the second word line WL2. At this time, the first electrode Dp of the spare unit PTR_U may be electrically connected to the second voltage line VL2, and the second electrode Sp of the spare unit PTR_U may be electrically connected to the anti-fuse AF. As another example, as shown in FIG. 27, the gate electrode Gp of the spare unit PTR_U may be electrically connected to the second word line WL2 through the anti-fuse AF.

In some embodiments, when applying the second gate voltage to the second word line WL2, the anti-fuse AF may be programmed to have a low resistance value, and accordingly, the spare unit PTR_U may function as a transistor between the second voltage line VL2 and the first voltage line VL1 through the anti-fuse AF.

While this disclosure has been described in connection with what is presently considered to be practical embodiments, it is to be understood that the inventive concepts are not limited to the disclosed embodiments, but, on the contrary, are intended to cover various modifications and equivalent arrangements included within the scope of the appended claims.

## Claims

1. A semiconductor device comprising:
a main transistor; and
an anti-fuse connected to one terminal of the main transistor,
wherein the main transistor includes
a main channel layer,
a main gate electrode above the main channel layer, and
a main source electrode and a main drain electrode on both sides of the main gate electrode, respectively, the main source electrode and the main drain electrode being connected to the main channel layer,
the anti-fuse includes
a sub-channel layer including a sub-drift area with a 2-dimensional electron gas, a sub-barrier layer above the sub-channel layer, the sub-barrier layer including a material having an energy band gap different from that of the sub-channel layer,
a sub-gate electrode above the sub-channel layer,
a gate semiconductor pattern between the sub-channel layer and the sub-gate electrode, and
a sub-source electrode above the sub-channel layer, the sub-source electrode being on one side of the sub-gate electrode, and
wherein the main source electrode and the sub-gate electrode, or the main source electrode and the sub-source electrode, are electrically connected to each other.

2. The semiconductor device of claim 1, further comprising:
a first protection layer covering the sub-barrier layer, and
a second protection layer covering the main source electrode, the sub-gate electrode, and the first protection layer,
the anti-fuse further includes a first connection wiring, the first connection wiring being above the second protection layer.

3. The semiconductor device of claim 2, wherein:
the first protection layer covers the sub-gate electrode, and
the first connection wiring penetrates the second protection layer and the first protection layer and is connected to the sub-gate electrode.

4. The semiconductor device of claim 1, 2 or 3, wherein:
the main gate electrode is electrically connected to a word line that is configured to apply a first gate voltage or a second gate voltage greater than the first gate voltage, and
the sub-source electrode is electrically connected to a first voltage line that is configured to apply a first power voltage, and
the second gate voltage is greater than a breakdown voltage of the gate semiconductor pattern.

5. The semiconductor device of claim 4, wherein:
the first gate voltage is smaller than the breakdown voltage of the gate semiconductor pattern.

6. The semiconductor device of any one of claims 1 to 5, wherein:
the main gate electrode is electrically connected to a first word line that is configured to apply a first gate voltage,
the sub-gate electrode is electrically connected to a program voltage line that is configured to apply a program voltage, and
the program voltage is greater than a destruction voltage of the gate semiconductor pattern.

7. The semiconductor device of any one of claims 1 to 6, wherein:
the main transistor further includes
a main barrier layer above the main channel layer, the main barrier layer including a material having an energy band gap different from that of the main channel layer, and
a gate semiconductor layer between the main barrier layer and the main gate electrode.

8. The semiconductor device of claim 7, wherein the gate semiconductor pattern includes a same material as the gate semiconductor layer.

9. The semiconductor device of any one of claims 1 to 8, further comprising a separation structure between the anti-fuse and the main transistor and penetrating the barrier layer.

10. The semiconductor device of claim 9, wherein:
the main gate electrode and the sub-gate electrode extend in one direction, and
along another direction intersecting the one direction, a width of the main transistor is greater than or equal to a width of the anti-fuse along the another direction.

11. The semiconductor device of any one of claims 1 to 10, wherein:
the anti-fuse further includes
a sub-drain electrode on another side of the sub-gate electrode, the another side of the sub-gate electrode being opposite to the one side of the sub-gate electrode, and
a second connection wiring connecting the sub-source electrode and the sub-drain electrode.

12. The semiconductor device of claim 11, wherein:
the sub-drain electrode is on a same layer as the main drain electrode, and
the sub-source electrode is on a same layer as the main source electrode.

13. The semiconductor device of claim 12, wherein:
the sub-drain electrode includes a same material as the main drain electrode, and
the sub-source electrode includes a same material as the main source electrode.

14. The semiconductor device of any one of claims 1 to 13, wherein:
the sub-channel layer is on a same layer as the main channel layer and includes a same material as the main channel layer.

15. The semiconductor device of any one of claims 1 to 14, wherein:
the gate semiconductor pattern includes AIN, GaN, InN, InGaN, AlGaN, AllnN, AllnGaN, or a combination thereof.

## Amended claims

### Amended claims in accordance with Rule 137(2) EPC.

1. A semiconductor device comprising:
a main transistor (MTR); and
an anti-fuse (AF) connected to one terminal of the main transistor (MTR),
wherein the main transistor (MTR) includes
a main channel layer (132m),
a main gate electrode (155m) above the main channel layer (132m), and
a main source electrode (173m) and a main drain electrode (175m) on both sides of the main gate electrode (155m), respectively, the main source electrode (173m) and the main drain electrode (175m) being connected to the main channel layer (155m), the anti-fuse (AF) includes:
a channel layer (132s) including a drift area (DTR) with a 2-dimensional electron gas (134),
a barrier layer (136s) above the channel layer (132s), the barrier layer (136s) including a material having an energy band gap different from that of the channel layer (132s),
a gate electrode (155s) above the channel layer (132s),
a gate semiconductor pattern (310) between the channel layer (132s) and the gate electrode (155s), and
a source electrode (173s) above the channel layer (132s), the source electrode (173s) being on one side of the gate electrode (155s), and
wherein the main source electrode (173m) and the gate electrode (155s), or the main source electrode (173m) and the source electrode (173s), are electrically connected to each other,
wherein when a voltage smaller than a breakdown voltage of the gate semiconductor pattern (310) is applied to the gate electrode (155s) of the anti-fuse (AF) a Schottky contact is maintained between the gate semiconductor pattern (310) and the gate electrode (155s), and
when a voltage greater than a breakdown voltage of the gate semiconductor pattern (310) is applied to the gate electrode (155s) of the anti-fuse (AF) the Schottky contact is converted into an ohmic contact.

2. The semiconductor device of claim 1, further comprising:
a first protection layer (140) covering the barrier layer (136s), and
a second protection layer (180) covering the main source electrode (173m), the gate electrode (155s), and the first protection layer (140),
the anti-fuse (AF) further includes a first connection wiring (410), the first connection wiring (410) being above the second protection layer (180).

3. The semiconductor device of claim 2, wherein:
the first protection layer (140) covers the gate electrode (155s), and
the first connection wiring (410) penetrates the second protection layer (180) and the first protection layer (140) and is connected to the gate electrode (155s).

4. The semiconductor device of claim 1, 2 or 3, wherein:
the main gate electrode (155m) is electrically connected to a word line (WL) that is configured to apply a first gate voltage or a second gate voltage greater than the first gate voltage, and
the source electrode (173s) is electrically connected to a first voltage line (VL1) that is configured to apply a first power voltage, and
the second gate voltage is greater than a breakdown voltage of the gate semiconductor pattern (310).

5. The semiconductor device of claim 4, wherein:
the first gate voltage is smaller than the breakdown voltage of the gate semiconductor pattern (310).

6. The semiconductor device of any one of claims 1 to 5, wherein:
the main gate electrode (155m) is electrically connected to a first word line (WL1) that is configured to apply a first gate voltage,
the gate electrode (155s) is electrically connected to a program voltage line (PL) that is configured to apply a program voltage, and
the program voltage is greater than a breakdown voltage of the gate semiconductor pattern (310).

7. The semiconductor device of any one of claims 1 to 6, wherein:
the main transistor (MTR) further includes
a main barrier layer (136m) above the main channel layer (132m), the main barrier layer (136m) including a material having an energy band gap different from that of the main channel layer (132m), and
a gate semiconductor layer (152) between the main barrier layer (136m) and the main gate electrode (155m).

8. The semiconductor device of claim 7, wherein the gate semiconductor pattern (310) includes a same material as the gate semiconductor layer (152).

9. The semiconductor device of any one of claims 1 to 8, further comprising a separation structure (160) between the anti-fuse (AF) and the main transistor (MTR) and penetrating the barrier layer (136s).

10. The semiconductor device of claim 9, wherein:
the main gate electrode (155m) and the gate electrode (155s) extend in one direction, and
along another direction intersecting the one direction, a width of the main transistor (MTR) is greater than or equal to a width of the anti-fuse (AF) along the another direction.

11. The semiconductor device of any one of claims 1 to 10, wherein:
the anti-fuse (AF) further includes,
a drain electrode (175s) on another side of the gate electrode (155s), the another side of the gate electrode (155s) being opposite to the one side of the gate electrode (155s), and
a second connection wiring (420) connecting the source electrode (173s) and the drain electrode (175s).

12. The semiconductor device of claim 11, wherein:
the drain electrode (175s) is on a same layer as the main drain electrode (175m), and
the source electrode (173s) is on a same layer as the main source electrode (173m).

13. The semiconductor device of claim 12, wherein:
the drain electrode (175s) includes a same material as the main drain electrode (175m), and
the source electrode (173s) includes a same material as the main source electrode (173m).

14. The semiconductor device of any one of claims 1 to 13, wherein:
the channel layer (132s) is on a same layer as the main channel layer (132m) and includes a same material as the main channel layer (132m).

15. The semiconductor device of any one of claims 1 to 14, wherein:
the gate semiconductor pattern (310) includes AIN, GaN, InN, InGaN, AlGaN, AllnN, AllnGaN, or a combination thereof.
